# EUROPÄISCHE PATENTANMELDUNG

(11) **EP 2 605 092 A1**
(43) Veröffentlichungstag der Anmeldung: **19.06.2013**
(21) Anmeldenummer: 11193072.3
(22) Anmeldetag: 12.12.2011
(51) Int. Cl.: G05B 19/042, H01R 9/26, H05K 7/14

(54) **Modular konfigurierbares Hardwaresystem mit systemeigenem Bus sowie Verfahren zum Betreiben des Hardwaresystems**

(71) Anmelder: Benteler Automobiltechnik GmbH, 33102 Paderborn (DE)
(72) Erfinder: Roser, Jürgen, 38442 Wolfsburg (DE); Grünewald, Marek, 38118 Braunschweig (DE); Knye, Florian, 38104 Braunschweig (DE)
(74) Vertreter: Griepenstroh, Jörg

(57) **Zusammenfassung**

Die vorliegende Erfindung betrifft ein Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere für den Einsatz für Automotiveanwendungen. Das Hardwaresystem (1) weist eine Grundplatine mit einem Mastercontroller und mindestens eine Zusatzplatine mit einem Slavecontroller auf, wobei erfindungsgemäß der Mastercontroller und der Slavecontroller über einen systemeigenen Bus miteinander zu kommunizieren. Das Hardwaresystem (1) ist modular erweiterbar, jeder weitere Slavecontroller jedenfalls mit über den systemeigenen Bus angesteuert werden kann. Hierdurch ergibt sich ebenfalls ein erfindungsgemäßes Verfahren zum Betreiben des Hardwaresystems in harter Echtzeit.

## Beschreibung

Die vorliegende Erfindung betrifft ein modularkonfigurierbares Hardwaresystem zur Modellbildung, Messung, Prüfung, Regeleung und/oder Steuerung von elektrischen Schaltkreisen, insbesondere zum Einsatz in Automotiveanwendungen gemäß den Merkmalen im Oberbegriff von Patentanspruch 1.

Die vorliegende Erfindung betrifft weiterhin ein Verfahren zum Betreiben des Hardwaresystems gemäß den Merkmalen im Patentanspruch 13.

Bei der aktuellen Entwicklung von Kraftfahrzeugen spielt der Einbau von Elektronikkomponenten eine immer stärkere Rolle. Zu den originären elektrischen Verbrauchern in einem Kraftfahrzeug, wie beispielsweise der Motorelektronik oder aber der Beleuchtungsanlage, kommt eine Vielzahl an elektrischen Fahrerassistenz- sowie Komfortsystemen.

Auf seiten der Fahrerassistentsysteme gibt es Basiskomponenten, über die nahezu jedes neu gebaute Fahrzeug verfügt. Hierzu zählen ein Antiblockiersystem sowie ein elektronisches Stabilitätsprogramm. Beide Systeme nutzen eine Vielzahl von Sensoren und Aktoren, die an verschiedenen Orten des Kraftfahrzeugs angeordnet sind. So gibt es beispielsweise Radsensoren, die direkt im Bereich der Räder angeordnet sind, sowie Beschleunigungssensoren, die zentral im Kraftfahrzeug positioniert sind. Zur Auswertung der Sensorsignale sind wiederum verschiedene Steuergeräte in dem Kraftfahrzeug angeordnet, die über Regeleingriffe in die Motorelektronik oder aber das Bremssystem kritische Fahrzustände vermeiden.

Darüber hinaus verfügen Kraftfahrzeuge heutzutage über Sensoren, die permanent Umgebungsdaten sammeln und auswerten und somit einen Rückschluss über die aktuellen klimatischen Bedingungen sowie die Wetterlage oder auch die Stausituation zulassen. Auf Basis dieser Datenauswertung verändern sich dann die Betriebsfunktionen für Scheibenwischer, Klimaautomatik oder aber auch Stabilitätseingriffe in das Fahrverhalten. Beispielsweise wird bei regnerischem Wetter die Gebläsefunktion der Klimaautomatik auf die Scheiben erhöht sowie die Scheibenwischersensibilität verstärkt, so dass der Fahrer stets freie Sicht erhält.

Zur Vernetzung der einzelnen Elektronikkomponenten innerhalb des Kraftfahrzeugs, insbesondere der Sensoren, Steuergeräte und Aktoren untereinander, sind diese über Kabelleitungen mit dem Bordnetz und miteinander gekoppelt. Da die stetig zunehmende Vielzahl von Elektronikbauteilen eine schier unendliche Zahl verschiedener Kabelleitungen erfordern würde, kommunizieren die Elektronikkomponenten innerhalb eines Kraftfahrzeugs über mindestens ein BUS-Signal untereinander. Zumeist handelt es sich dabei um einen Can-BUS. Durch die Verwendung eines BUS-Kommunikationsweges der einzelnen Elektronikkomponenten untereinander ist es möglich, mehrere Komponenten an eine entsprechende Datenleitung zu koppeln. Die Datenleitung selber besteht dabei wiederum aus zwei, drei oder mehr einzelnen Kabelleitungen. Über die Datenleitung ist es möglich, verschiedene Kommunikationssignale zu versenden, wobei sich die einzelnen Elektronikbauteile, wie Steuergeräte, Sensoren und Aktoren, dann die jeweils relevanten Daten aus der Kommunikationsleitung auslesen bzw. Daten über die Kommunikationsleitung senden.

In einem Kraftfahrzeug werden jedoch verschiedenste Bauteile von Kraftfahrzeugzulieferern verbaut. Dabei gilt es, die Zuliefererbauteile der verschiedensten Zulieferhersteller auf einen Standard des jeweiligen Kraftfahrzeugherstellers oder aber des jeweiligen Kraftfahrzeugtyps zu bringen, so dass diese kompatibel in dem Kraftfahrzeug selber miteinander kommunizieren und agieren.

Bei technischen Verbesserungen während des Produktlebenszyklus einer Baureihe eines Kraftfahrzeugs, beispielsweise der Seriennachrüstung eines neueren Navigationssystems im Zuge einer Produktauffrischung, gilt es, Elektronikkomponenten mit neuesten Standards in ein bereits Jahre älteres, bestehendes Elektroniksystem zu implementieren.

Zur Entwicklung von Kraftfahrzeugen sind daher für jedes einzelne Bauteil aufwendige Tests und Probeläufe zu absolvieren. Im Anschluss hieran werden die einzelnen Komponenten zu Baugruppen zusammengefügt, die wiederum Tests und Probeläufe absolvieren. Alle Bauteilkomponenten werden dann in Prototypenfahrzeugen vereint und auch hier wiederum ausgiebig getestet. Die Erkenntnis aus der Entwicklung der Komponenten sowie der Prototypenkraftfahrzeuge fließen dann in Vorserienmodelle ein, wobei die bis dahin gesammelten Erkenntnisse eine spätere Volumenproduktion des Kraftfahrzeugmodels, insbesondere ohne Elektronikprobleme, zulassen.

Damit ein Elektronikbauteil eigenständig entwickelt und getestet werden kann, ohne in einem Kraftfahrzeug selber eingebaut zu sein, bedarf es der Simulation der Kraftfahrzeugumgebung. Hierzu hat sich die Hardware in the loop Methode etabliert, bei der eine reale elektronische Bauteilkomponente oder aber eine reale mechatronische Bauteilkomponente über ihre Ein- und Ausgänge an eine simulierte Umgebung angeschlossen wird. Der Simulator simuliert dabei in einem Zusammenspiel aus Hardware und Software die reale Umgebung des Gesamtsystems, also des Kraftfahrzeugs oder aber einer Unterbaugruppe einer Baugruppe des Kraftfahrzeugs. Hierzu bedarf es entsprechender Hardware sowie Entwicklungssoftware bei der Entwicklung des Bauteils. Als Hardware fungieren zumeist Computer, die in Laboren bzw. auf Prüfständen in Großgehäusen als Einschubsteckplätze modular aufgebaut sind. Solche Computergehäuse sind stationär an den Laborbetrieb gebunden und aufgrund ihrer äußeren Abmessungen sowie ihrer Verkablung zu den zu erprobenden oder zu evaluierenden Bauteilen stationär gebunden. Zur Erweiterung der Funktionsfähigkeit einer entsprechenden Prüfstandshardware werden neue Einsteckmodule eingesteckt, die dann eine weitere Reihe von Sensoren oder Aktoren ansteuern oder aber auswerten kann. Hierbei kommt es unter Umständen zu hardwaretechnischen und auch softwaretechnischen Kompatibilitätsproblemen auf Seiten des Simulators.

Zur Auswertung und Bedienung eines Simulators bedarf es wiederum eines Personal Computers mit Eingabemaske, über die dann die Simulationsumgebung erschaffen, simuliert und ausgewertet wird.

Zur Erprobung in einem Kraftfahrzeug, also auch zur mobilen Erprobung während einer Testfahrt, eignen sich vorerwähnte Simulatoren dann wiederum nicht. Hier wird zumeist auf Dummies oder aber Dongel zurückgegriffen, die bei Testfahrten ausschließlich eine Auswertung oder aber Simulation vornehmen, deren Ergebnisse im Nachhinein ausgewertet werden. Es ist jedoch auch mobile Testhardware bekannt, bei der entsprechende Gehäuse in einem Kraftfahrzeug auf dem Beifahrersitz oder aber im Kofferraum angeordnet werden, in die dann wiederum verschiedenste Einsteckmodule einbaubar sind, um so für einen jeweiligen Anwendungsfall die erforderliche Testhardware bereit zu stellen.

Aufgabe der vorliegenden Erfindung ist es, ausgehend vom Stand der Technik, ein modular konfigurierbares Hardwaresystem bereit zu stellen, das sowohl stationär als auch mobil einsetzbar ist und das gegenüber aus dem Stand der Technik bekannten Hardwaresystemen bedeutend einfacher einsetzbar ist.

Die zuvor genannte Aufgabe wird mit einem Hardwaresystem zur Modellbildung, Messung, Prüfung, Regelung und/oder Steuerung von elektrischen Schaltkreisen und/oder Datennetzen und/oder Sensoren und/oder Aktoren gemäß den Merkmalen in Patentanspruch 1 gelöst.

Die vorliegende Erfindung wird weiterhin durch ein Verfahren zum Betreiben des Hardwaresystems gemäß den Merkmalen im Patentanspruch 13 gelöst.

Vorteilhafte Ausführungsvarianten der vorliegenden Erfindung sind Gegenstand der abhängigen Patentansprüche.

Das Hardwaresystem zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen weist eine Grundplatine mit einem Mastercontroller und mindestens eine Zusatzplatine mit einem Slavecontroller auf. Das Hardwaresystem ist erfindungsgemäß dadurch gekennzeichnet, dass der Mastercontroller und der Slavecontroller über einen systemeigenen Bus, vorzugsweise über einen SPI-Bus, des Hardwaresystems kommunizieren, wobei an dem Slavecontroller mindestens ein Einsteckmodul anschließbar ist und über das Einsteckmodul externe Regler und/oder Messsensoren und/oder Aktoren und/oder Datennetze auslesbar und/oder steuerbar sind.

Im Rahmen der Erfindung weist das Hardwaresystem ein Gehäuse auf, das modular optional erweiterbar ist. Das Gehäuse setzt sich aus einem Grundmodul, optionalen Zwischenmodulen und einem Deckelmodul zusammen, wobei die einzelnen Module untereinander über den systemeigenen Bus des Hardwaresystems kommunizieren. Jede Modulebene weist einen Controller auf, wobei in dem Grundmodul ein Mastercontroller angeordnet ist, und die anderen Ebenen diesem Mastercontroller als Slavecontroller unterstellt werden.

Das erfindungsgemäße Hardwaresystem ist beliebig erweiterbar, wobei die einzelnen Modulebenen durch beliebige Anordnung von Zwischenmodulen turmartig und/oder sandwichartig aufeinandersetzbar sind. In die einzelnen Modulebenen sind im Rahmen der Erfindung Einsteckmodule lösbar einsteckbar, die ein einfaches und sicheres Anschließen von externen Reglern und/oder Messsensoren und/oder Aktoren ermöglichen sowie Datennetze über das Einsteckmodul auslesbar und/oder übersetzbar sind.

Bei Reglern, Sensoren und/oder Aktoren handelt es sich dabei im Rahmen der Erfindung um alle erdenklichen Sensoren, Aktoren und/oder Regler, die im Rahmen von Prüfstandsarbeiten oder Prototypen Erprobung eingesetzt werden. Ferner handelt es sich um alle erdenklichen elektrischen, elektronischen und mechatronischen Bauteile, die zur Erprobung oder aber auch zur Evaluierung als Serienbauteile insbesondere in Automotiveanwendungen eingesetzt werden.

Im Rahmen der Erfindung ist es aufgrund der Kommunikation des Mastercontrollers mit den Slavecontrollern über den systemeigenen Bus möglich die zu tauschenden Datenmengen schnell und unkompliziert über die einzelnen Modulebenen zu leiten. Jedes Modul liest dann aus dem systemeigenen Bus wiederum die für das Modul selber bzw. die Einsteckmodule relevanten Daten aus und verwertet diese auf der Modulebene weiter. Der systemeigene Bus kann dabei im Rahmen der Erfindung jedes beliebige Signal sein, mit dem es möglich ist eine Datenweiterleitung für mehrere Teilnehmer zu ermöglichen.

Im Rahmen der Erfindung wird besonders bevorzugt ein SPI-Bus eingesetzt, wobei es sich bei dem SPI-Bus um einen Serial Peripheral Interface handelt. Der SPI-Bus weist einen einfachen Standard für einen synchronen seriellen Datenbus auf, mit dem digitale Schaltungen nachdem Master Slaveprinzip miteinander verbunden werden können.

Bevorzugt weist das Hardwaresystem eine gemeinsame Busleitung auf, die sich insbesondere aus drei gemeinsamen Leitungen zusammensetzt, an denen jeder Teilnehmer, also jede Modulebene angeschlossen ist. Im Rahmen der Erfindung kann das Hardwaresystem jedoch auch mehr oder weniger Leitungen haben, die die einzelnen Modulebenen miteinander verbinden. Vorzugsweise wird ein systemeigener Bus derart gewählt, dass unterschiedliche Taktfrequenzen über den Bus übertragbar sind,so dass der Bus innerhalb unterschiedlicher Taktfrequenzen arbeiten kann. Der systemeigene Bus des erfindungsgemäßen Hardwaresystems zeichnet sich insbesondere dadurch aus, dass er eine große Spannbreite von verschiedenen auch prinzipiell zueinander inkompatiblen Geräten ermöglicht.

Insbesondere bietet der systemeigene Bus des Hardwaresystems, vorzugsweise als serieller Bus, die Möglichkeit die modulare Erweiterungsfähigkeit des Hardwaresystems zu realisieren. Jedes Einsteckmodul besitzt einen Speicherbaustein, auf den die Modulkennung des Einschubmoduls wiederum hinterlegt ist. Bei Programmstart oder aber auch bei Reset des Hardwaresystems fragt der Mastercontroller alle Slavecontroller ab, welche Einsteckmodule potentiell oder aber möglicherweise in das Hardwaresystem eingesteckt sind. Die Slavecontroller haben wiederum auf der Modulebene eines Zwischenmoduls direkten Zugriff auf das Einsteckmodul.

Die Istverbauliste der Einsteckmodule wird mit einer im Programmcode hinterlegten Sollverbauliste verglichen und kann somit Abweichungen feststellen. Die Sollverbauliste kann auf Grund der einfachen Bedienbarkeit des Hardwaresystems direkt am Hardwaresystem oder aber über ein externes Kontrollinstrument beispielsweise einen Computer festgelegt, adaptiert oder geändert werden. Der Vergleich der Sollverbauliste mit der Istveblauliste kann auch während des Betriebs des Hardwaresystems manuell oder aber automatisch zyklisch durchgeführt werden, umso zu erkennen, ob Laufzeit Einsteckmodule entfernt bzw. eingesteckt werden oder aber ob Fehler oder Ausfälle an bereits eingesteckten Einsteckmodulen aufgetreten sind. Wird eine Abweichung festgestellt, kann eine entsprechende Fehlermeldung erzeugt werden und/oder der Programmablauf unterbrochen oder aber umgestellt werden.

In einer Grundausführungsvariante des Hardwaresystems ist die Grundplatine in einem Grundmodul angeordnet, wobei in das Grundmobil optional ein Einsteckmodul einsteckbar ist, wobei das Einsteckmodul über den Mastercontroller ansteuerbar ist. Das Hardwaresystem weist somit in einfachster Ausführungsvarainte ein Gehäuse auf, vorzugsweise ein metallisches Gehäuse insbesondere ein leichtmetallisches Gehäuse, in dem eine Grundplatine mit dem Mastercontroller angeordnet ist. In das Gehäuse besteht die Möglichkeit ein Einsteckmodul einzustecken, dass wiederum mit der Grundplatine gekoppelt wird und es somit ermöglicht ein externes Peripheriebauteil, beispielsweise einen Aktor, einen Sensor anzusteuern oder zu regeln bzw. auszulesen oder aber dem Hardwaresystem es ermöglicht mit einem externen Datennetz, beispielsweise einem Kraftfahrzeugbus zu kommunizieren. Das Einsteckmodul ist dann direkt über den Mastercontroller ansteuerbar.

Auf der Modulebene des Grundmoduls kommuniziert der Mastercontroller mit dem in das Grundmodul lösbar eingesteckte Einsteckmodul über den systemeigenen Bus des Hardwaresystems oder der Mastercontroller kommuniziert mit dem Einsteckmodul über einen von dem systemeigenen Bus verschiedenes Datenprotokoll. Hierbei kann es sich dann um ein Datenprotokoll handeln, dass es ermöglicht eine direkte Kommunikation zwischen dem Mastercontroller und dem Einsteckmodul herzustellen. Ebenfalls kann ein zusätzlicher Controller in dem Grundmodul angeordnet sein, der aus dem systemeigenen Bus des gesamten Hardwaresystems die für das Einsteckmodul erforderlichen Daten oder Steuerungssignale ausliest und dann wiederum ebenenintern auf Modulebene des Grundmoduls mit dem Einsteckmodul kommuniziert.

Ein jeweiliges Einsteckmodul des Hardwaresystems, hierbei kann es sich beispielsweise um ein Einsteckmodul in das Grundmodul oder aber auch um ein Einsteckmodul in ein Zwischenmodul handeln, ist mit einem externen Element zum Datenaustausch und/oder elektrisch gekoppelt, wobei das Einsteckmodul und das externe Element das Datenprotokoll des externen Elements zur Kommunikation nutzen. Im Rahmen der Erfindung ist das Einsteckmodul über elektrische Leitungen physisch mit dem externen Element gekoppelt. Hierbei kann es sich beispielsweise um Leistungen zur Stromversorgung oder zum Datenaustausch handeln.

Als externes Element können dann wiederum Stellaktoren an die Einsteckmodule gekoppelt sein, die über einen Treiber der in dem Einsteckmodul platziert ist ansteuerbar sind. Die Steuerungsbefehle erhält das Einsteckmodul jedoch über den systemeigenen Bus von dem Controller der Ebene in der das Einsteckmodul angeordnet ist. Als externes Element kann beispielsweise auch ein Messsensor an das Einsteckmodul angeschlossen sein.

Ebenfalls kann es sich bei dem Einsteckmodul um eine Art Modem handeln, dass es dem Hardwaresystem ermöglicht mit einem externen Datennetz zum Datenaustausch zu kommunizieren. Beispielsweise kann das Einsteckmodul die Fähigkeit besitzen einen kraftfahrzeugeigenen Bus bzw. einen Canbus auszulesen oder aber mit diesen zu kommunizieren. Die entsprechend ausgelesenen Daten gibt das Einsteckmodul dann wiederum über die Modulebene an den Controller weiter, wobei der Controller die Daten über den systemeigenen Bus des Hardwaresystems an den Mastercontroller weitergibt und diese von dort aus weiter verarbeitet werden können. Beispielsweise sind die relevanten Daten dann über ein Display direkt an dem Hardwaresystem anzeigbar, über eine Datenspeichereinheit in dem Hardwaresystem speicherbar oder aber über eine andere oder die gleiche Modulebene des Hardwaresystems an einen externen Computer oder eine externe Auswerteeinrichtung weiterleitbar. Ebenfalls sind auf umgekehrten Wege Daten über das Einsteckmodul in das externe Datennetz einspeisbar, so dass beispielsweise dem Datennetz eine Simulationsumgebung simuliert wird.

Im Rahmen der Erfindung ist bei Anschluss des Einsteckmoduls mit einem externen Element nicht zwingend eine physische Verbindung, beispielsweise in Form eines Netzwerkkabels oder aber in Form von physisch vorhandenen Drahtleitungen zur Übertragung eines Datensignals notwendig, es kann auch eine drahtlose Datenübertragung stattfinden.

Das externe Element und das Einsteckmodul kommunizieren jedoch über das Datenprotokoll des externen Elementes. Gerade hier liegt ein erfindungswesentlicher Vorteil, da die in dem Hardwaresystem selber weitergeleiteten Daten zur Simulation, Auswertung oder Prüfung von an das Hardwaresystem angeschlossenen Peripheriebauteilen auf die notwendigen Daten begrenzbar sind. Auf einer jeweiligen Modulebene bzw. zwischen dem Einsteckmodul und dem an das Einsteckmodul angeschlossenen externen Element können somit die Daten jeweils auf das Wesentliche beschränkt werden, weshalb über dem hardwaresystemeigenen Bus nur von dem jeweiligen Master- oder Slavecontroller gefilterte Daten geleitet werden. Hierdurch wird es ermöglicht eine Vielzahl von verschiedenen Modulebenen an das Hardwaresystem anzuschließen und bis zu mehrere dutzend Einsteckmodule mit jeweils an das Einsteckmodul angeschlossenen externen Elementen, wobei das Hardwaresystem dennoch unter harten echtzeitfähigen Bedingungen arbeiten kann.

Der erfindungsgemäße Aufbau aus modular erweiterbarem Gehäuse sowie der systemeigene Datenaustausch des Hardwaresystems mit einer sehr einfachen modularen Erweiterungsmöglichkeit über die Einsteckmodule bietet erfindungsgemäß insbesondere den Vorteil, dass aufwendige Zeiten zum Aufbau eines Prüfstandes oder einer Simulationsumgebung entfallen. Auf Grund der modulartigen Erweiterbarkeit sowie der einfachen Koppelung der Einsteckmodule mit den jeweiligen Modulebenen des Grundmoduls und oder der Zwischenmodule ist ebenfalls ein fehlerfreier Aufbau möglich, da aufwendige Rüstzeiten für die Verkabelung von Messaufbauten entfallen. Im Falle falschen Anschlusses von physischen Kabelleitungen oder auf Grund von Inkompatibilitäten der einzelnen Hard- und Softwareprodukte von verschiedensten Prüfstandsaufbauten sowie zur Überprüfung, Messung, Regelung oder Steuerung verschiedenster eingesetzter Sensoren oder Aktoren entfallen ebenfalls gänzlich.

Das jeweilige Einsteckmodul dient somit als Schnittstelle zwischen externem Element und dem Hardwaresystem. Es wandelt das externe Datenprotokoll der externen Elemente in ein zumindest ebeneninternes Datenprotokoll der Modulebene beispielsweise des Zwischenmoduls um und kommuniziert mit dem Controller der Modulebene. Im Falle eines Zwischenmodul mit dem Slavecontroller. Somit entsteht auf einer Ebene eines Zwischenmoduls ein ebeneninterner Datentransfer zwischen dem Einsteckmodul und dem Controller des Zwischenmoduls. Hierbei ist es bereits wiederum möglich die nur relevanten Daten des an das Zwischenmodul angeschlossenen externen Elementes an den Controller und somit wiederum über den ebeneninternen Bus des Hardwaresystems an einen Benutzer oder aber an eine Speichereinheit oder Anzeige weiterzugeben. Ebenfalls wird hierüber eine hohe Kompatibilität sichergestellt, da die Treiberhard- und Software zum Betreiben des externen Elementes auf dem Einsteckmodul hinterlegt sind, wobei das Einsteckmodul kompatibel zu dem Hardwaresystem ist.

Hierdurch wird es wiederum ermöglicht, dass nur für den primären Regelungsvorgang und/oder Messvorgang relevante Daten über den systemeigenen Bus ausgetauscht werden. Das System ist somit hart echtzeitfähig, auch bei mehreren Dutzend angeschlossenen Aktoren, Sensoren und/oder bei Auslesen von sogar mehreren verschiedenen externen Datennetzen.

Das erfindungsgemäße Hardwaresystem zeichnet sich weiterhin durch eine Autoadressierungsmöglichkeit aus. Hierbei wird bei Neustart und/oder Reset oder aber bei Einstecken eines neuen Einsteckmoduls und/oder in sich wiederholenden zeitlichen Abständen eine Autoadressierung aller im System angeordneten Modulebenen und/oder Zwischenmodule und/oder Einsteckmodule durchgeführt, bevorzugt ausgehend von dem Grundmodul, insbesondere ausgehend von dem Mastercontroller des Grundmoduls und ganz besonders bevorzugt von dem ersten Einsteckmodul in dem Grundmodul und/oder von dem ersten auf das Grundmodul folgende Einsteckmodul. Bei dem ersten auf das Grundmodul folgenden Einsteckmodul handelt es sich bevorzugt um das Einsteckmodul, dass in dem dem Grundmodul benachbartem Zwischenmodul angeordnet ist. Im Rahmen der Erfindung ist es über den systemeigenen Bus vorstellbar, dass jeweils nur die Master- und Slavecontroller der jeweiligen Modulebenen zueinander autoadressiert sind.

Im Rahmen der Erfindung ist es jedoch auch vorstellbar, dass jedes Einsteckmodul über einen Mikrocontroller verfügt, und sich die einzelnen Mikrocontroller der Einsteckmodule seriell autoadressieren. Hierzu muss jeder Mikrocontroller eine individuelle Nummer besitzen, um im Betrieb des Hardwaresystems individuell ansprechbar zu sein. Mikrocontroller 1 sendet somit ein Resetsignal an den Mikrocontroller 2, welcher sich daraufhin neu bootet. Der Mikrocontroller 2 sendet ein Resetsignal an Mikrocontroller 3, der sich daraufhin neu bootet und ein Resetsignal an Mikrocontroller 4 sendet, was sich bis zu der Anzahl der angeschlossenen Mikrocontroller an das Hardwaresystem fortsetzt.

Bevorzugt wird bei dem erfindungsgemäßen Hardwaresystem die Autoadressierung derart ausgeführt, dass der erste Mikrocontroller seine Empfängerleitung mit der Senderleitung vertauscht, so dass die Senderleitung zu der Empfängerleitung und die Empfängerleitung zur Senderleitung wird. Auf dieser Leitung wird dann eine Kennung an den zweiten Mikrocontroller gesendet, wobei danach der erste Mikrocontroller seinen ursprünglichen Zustand wiederherstellt. Der zweite Mikrocontroller vertauscht daraufhin wiederum seine Senderleitung mit seiner Empfängerleitung und sendet die Kennung um +1 erhöht an den dritten Mikrocontroller und stellt im Anschluss hieran seinen Ursprungszustand wieder her.

Damit eine serielle Schaltung der einzelnen Mikrocontrollerebenen übergreifend herstellbar ist, ist eine lösbare Steckverbindung der einzelnen Modulebenen untereinander mit einem versetzten Pin gekoppelt. Die Verbindung der Resetleitung der einzelnen Ebenen untereinander weist somit einen Pinversatz auf, so dass die einzelnen Modulebenen faktisch in Reihe geschaltet sind.

Im Rahmen der Erfindung ist dann jedes Einsteckmodul zentral von dem Mastercontroller aus über den systemeigenen Bus ansteuerbar. Ebenfalls ist es im Rahmen der Erfindung möglich das Einsteckmodul dezentral über jeweils einen Slavecontroller aus anzusteuern. Je nach aktueller Betriebsart, auszutauschender Datenmenge und Anforderung an die Echtzeitfähigkeit ist somit eine flexible Regelungs- und Steuerungsmöglichkeit des Hardwaresystems selbst mit einer Vielzahl angeschlossenen externen Elementen möglich. Auch ist ein paralleler Betrieb möglich, wobei der Mastercontroller direkt auf einzelne Einsteckmodule zugreift und andere Einsteckmodule indirekt über die jeweiligen Slavecontroller der Zwischenmodule anspricht.

Weiterhin sind besonders bevorzugt zwei oder mehr Einsteckmodule in einem Zwischenmodul zentral von einem in dem Zwischenmodul befindlichen Slavecontroller aus ansteuerbar. Auch hierdurch wird wiederum eine Filterungsfunktion der jeweiligen auf der Modulebene angeordneten Einsteckmodule vorgenommen. Die auszutauschenden Datenmengen der einzelnen Modulebenen untereinander werden hierdurch reduziert, weshalb es mit dem erfindungsgemäßen Hardwaresystem möglich ist selbst eine Vielzahl von in Reihe geschalteten Zwischenmodulen in harter Echtzeitumgebung zu betreiben.

Weiterhin besonders bevorzugt ist der Slavecontroller als Mikroprozessor ausgebildet, vorzugsweise ist der Slavecontroller durch zwei spiegelsymetrische auf der Zusatzplatine angeordnete Mikroprozessoren ausgebildet. Die Zusatzplatine selber ist dabei als Modulplatine des Zwischenmoduls ausgebildet und weist zusätzliche elektronische Bausteine beispielsweise in Form von Prozessoren oder Speichereinheiten auf. Durch den spiegelsymetrischen Aufbau des Slavecontrollers auf der Zusatzplatine des Zwischenmoduls wird wiederum ein redundanter ebeneninterner Betrieb ermöglicht. Für bestimme insbesondere sicherheitsrelevante Anwendungen kann ein redundanter Betrieb notwendig sein, so dass bei Ausfall eines der zwei spiegelsymetrischen Mikroprozessoren der andere Mikroprozessor die modulebeneninterne Kommunikation und somit die Ansteuerung der in das Modul eingesteckten Einsteckmodule übernimmt.

Zur Autoadressierung selber weist jedes Einsteckmodul einen Speicherbaustein auf, auf dem eine Einsteckmodulkennung gespeichert ist. Vorzugsweise handelt es sich dabei um einen EEPROM.

Die vorliegende Erfindung betrifft weiterhin ein Verfahren zum Betreiben eines Hardwaresystems, wobei das Hardwaresystem insbesondere zumindest eines der zuvor genannten Merkmale ausweist, und das Verfahren dadurch gekennzeichnet ist, dass ein externes Element mit einem Einsteckmodul kommuniziert, wobei das Einsteckmodul die bereitgestellten und/oder abgefragten Daten filtert und zu einem mit dem Einschubmodul gekoppelten Slavecontroller weitergibt und/oder von diesem empfängt und das der Slavecontroller die empfangenen oder gesendeten Daten über den systemeigenen Bus des Hardwaresystems an den Mastercontroller weitergibt oder von diesem empfängt.

Hierdurch ist es mit dem erfindungsgemäßen Hardwaresystem möglich eine Vielzahl von Aktoren und/oder Sensoren gleichzeitig zu regeln, zu steuern, zu messen, zu prüfen und/oder ebenfalls gleichzeitig eine Modelumgebung zu simulieren sowie mit externen Datennetzen zu kommunizieren. Gleichzeitig wird es auf Grund der Einsteckmodule ermöglicht, eine hohe Kompatibilität des erfindungsgemäßen Hardwaresystems sicherzustellen, da die Einsteckmodule zu dem Hardwaresystem kompatibel sind und jeweils bevorzugt eine Treiberhardware und eine Teibersoftware für das an das Einsteckmodul gekoppelte externe Element aufweisen. Aufwendige Prüfstandsaufbauten, sowie Verkabelungen und Treiberinstallationen so wie das Lösen von Kompatibilitätsproblemen entfallen bei den erfindungsgemäßen Hardwaresystem gänzlich.

Hierzu besteht bei dem erfindungsgemäßen Verfahren weiterhin die Möglichkeit das zwei Slavecontroller an den Mastercontroller angeschlossen werden und ein Datenprotokoll über den systemeigenen Bus gesendet wird, wobei jeder Slavecontroller die für ihn adressierten Daten aus dem Datenprotokoll ausliest und für ein ebeneninternes Datenprotokoll oder eine ebeneninterne Datenkommunikation verwendet, wobei über das ebeneninterne Datenprotokoll die Einsteckmodule über den jeweiligen Slavecontroller ansteuerbar sind. Die Einsteckmodule kommunizieren somit mit dem Slavecontroller und geben an diesen die von den an den Einsteckmodulen angeschlossenen externen Elementen empfangenen Daten weiter oder empfangen vom Slavecontroller Regelungs- oder Steuerungsbefehle, die sie wiederum an die angeschlossenen externen Elemente weiterleiten. Hierdurch entsteht eine Filterungsfunktion, so dass der systemeigene Bus des Hardwaresystems sich auf einen wesentlichen Datenaustausch reduzieren kann, wobei auf Grund der breiten Kompatibilität des systemeigenen Busses des Hardwaresystems Kompatibilitätsprobleme annähernd gänzlich vermieden werden.

Der Slavecontroller liest weiterhin auf Grund der Modulkennung des Einsteckmoduls die relevanten Daten aus dem systemeigenen Bus aus. Er gibt dann wiederum ebenenintern, beispielsweise auf der Ebene eines Zwischenmoduls, die relevanten Daten entweder direkt an das Einsteckmodul weiter und/oder er bereitet die ausgelesenen Daten für das Einsteckmodul auf.

Es ist weiterhin Bestandteil des erfindungsgemäßen Verfahrens, dass bei einem Neustart bzw. Hochfahren und/oder Programmstart des Hardwaresystems der Mastercontroller alle Slavecontroller bezüglich gesteckter und/oder aktivierter Einsteckmodule abfragt und eine Verbauliste erstellt, wobei die Verbauliste mit einer Sollverbauliste verglichen wird.

Bei Auftreten einer Differenz zwischen der Verbauliste und der Sollverbauliste wird weiterhin bevorzugt dann eine Fehlermeldung erzeugt. Im Rahmen der Erfindung ist es möglich die Sollverbauliste automatisch durch eine Initialisierung des Hardwaresystems bei Erstinbetriebnahme oder aber Wiederinbetiebnahme vorzunehmen oder die Sollverbauliste ebenfalls manuell zu editieren. Der Vergleich der Sollverbauliste mit der Verbauliste, also der Istverbauliste kann ebenfalls während des Betriebs des Hardwaresystems in zeitlichen Abständen durchgeführt werden, insbesondere in zyklischen Abständen. Diese Abstände sind dabei frei programmierbar beispielsweise in zeitlichen Intervallen. Somit kann das Hardwaresystem direkt feststellen, ob beispielsweise ein Teilnehmer des Hardwaresystems, also ein Einsteckmodul einen Fehler aufweist oder sich in einem nichtbetriebsfähigen Zustand befindet. Aufgrund der internen Kommunikation des Hardwaresystems über den systemeigenen Bus ist es jedoch wiederum möglich, dass das Hardwaresystem bei Auftreten eines Fehlers einer einzelne Komponente unbeschadet weiterbetrieben wird.

Ebenfalls ist es aufgrund des systemeigenen Busses des Hardwaresystems möglich das bei Ausfallen eines Slavecontrollers einer Zusatzplatine eines Zwischenmoduls die Ansteuerung der in das Zwischenmodul eingesteckten Einsteckmodule über den Slavecontroller einer anderen Zusatzplatine anzusteuern oder aber auch über den Mastercontroller die Einsteckmodule direkt anzusteuern. Weiterhin vorzugsweise weist jedes Einsteckmodul einen eigenen Mikrocontroller auf, wobei der eigene Mikrocontroller des Einsteckmoduls dann jeweils ebenenintern mit einem Slavecontroller der Ebene kommuniziert, vorzugsweise über ein ebeneninternes Datenaustauschprotokoll, insbesondere über einen ebeneninternen Bus. Auch durch diese Verfahrensvariante ist es wiederum möglich die ausgetauschte Datenmenge innerhalb des gesamten Hardwaresystems gering zu halten, da durch den jeweiligen Slavecontroller einer Ebene oder aber durch den Mikroprozessor eines Einsteckmoduls eine weitere Datenaufbereitung erfolgen kann.

Der Slavecontroller kommuniziert mit dem Mastercontroller über den systemeigenen Bus, wobei die Daten des Mastercontrollers über das Display und/oder eine externe Dateneinrichtung ausgelesen und/oder von dem Display und/oder von einer externen Dateneinrichtung eingegeben werden. Somit ist es möglich das Hardwaresystem von einer externen Dateneinrichtung aus zu betreiben. Beispielsweise kann dies ein an das Hardwaresystem angeschlossener Computer sein. Auf Grund der Möglichkeit der Integration eines Eingabedisplays, insbesondere eines Touchdisplays in dem Gehäuse des Hardwaresystems ist jedoch auch ein autarker Betrieb des Hardwaresystems, ohne zusätzliche externe Eingabegeräte möglich.

Über den Mastercontroller ist es wiederum möglich eine Modelbildungssoftware insbesondere Matlab Simulink in das Hardwaresystem einzubinden. Hierüber ist es möglich, nahezu jede beliebige Modelumgebung zu simulieren, so dass verschiedenste Elektronik oder aber mechatronische Komponenten mit dem erfindungsgemäßen Hardwaresystem betrieben, überprüft, gemessen oder ausgelesen werden können. Insbesondere bietet sich die Erprobung von einzelnen Bauteilen für Kraftfahrzeuge an, dass über das Hardwaresystem mit eingebundener Modelbildungssoftware und eine hierüber implementierten Simulationsumgebung ermöglicht wird ein gesamtes Kraftfahrzeug mit allen elektronikbauteilen sowie dem kraftfahrzeugeigenen Datennetz zu simulieren.

Im Rahmen der Erfindung ist es jedoch insbesondere möglich über das erfindungsgemäße Verfahren zum Betreiben des Hardwaresystems alle Ebenen untereinander in harter Echtzeit zu betrieben. Ebenfalls kann selbst bei Anschluss von 50 oder mehr Einsteckmodulen über den erfindungsgemäßen Aufbau des Hardwaresystems sowie das damit verbundene Verfahren zum Betreiben des Hardwaresystems eine harte Echtzeitumgebung simuliert werden. Auf Grund des modularen Aufbaus sowie der Autoadressierung ist es möglich selbst hochkomplexe Prüfstandsaufbauten mit zahlreichen Anschlussmöglichkeiten einfach schnell und überschaubar herzustellen und zu Betreiben. Zeiten für aufwendige Prüfstandsaufbauten, insbesondere Rüstzeiten sowie Zeiten für Fehlersuchen und/oder zur Herstellung von Kompatibilität der einzelnen Prüfstandkomponenten untereinander entfallen mit dem erfindungsgemäßen Hardwaresystem gänzlich.

Die Modulsteckverbindungen aller Module, also insbesondere aller Zwischenmodule, sind gleich, so dass bei Austausch und/oder Ergänzung und/oder Entnahme eines Moduls, insbesondere eines Zwischenmoduls, die Modulsteckverbindungen der verbleibenden Module wiederum in einfacher Weise lösbar ineinander steckbar sind. Somit können bei einem bereits in einer Umgebung implementierten Hardwaresystem in einfacher Art und Weise weitere Zwischenmodule ergänzt oder aber Zwischenmodule entfernt werden. Durch einfaches wiederum lösbares Ineinanderstecken der verbleibenden Module ist das Hardwaresystem sofort wieder einsatzfähig. Auch hier entfallen aufwendige Anschluss- oder Umbauarbeiten, insbesondere aufwendige Verkabelungsarbeiten. Durch wiederum einfaches Einstecken der Einsteckmodule in das Gehäuse des Hardwaresystems können verschiedenste Peripheriebauteile bzw. Sensoren oder Aktoren wiederum betriebssicher an das Hardewaresystem gekoppelt werden.

Als Einsteckmodule können beispielsweise Einsteckmodule zur Verbindung mit einem Can-BUS, einem Lin-BUS, einem USB-Steckplatz oder aber auch einem Speicherkartensteckplatz in das Hardwaresystem eingesteckt werden. Ebenfalls ist es vorstellbar, Einsteckmodule anzuordnen, die eine entsprechende Hardware sowie einen Treiber für externe Peripheriebauteile, beispielsweise Sensoren oder Aktoren, aufweisen. Auch können Module mit D/A-Wandlern, analog in/out oder aber auch digital in/out Anschlüssen in das Gehäuse eingesteckt werden.

Das Hardwaresystem weist erfindungsgemäß weiterhin ein Deckelmodul mit einer Bedieneinheit auf, vorzugsweise handelt es sich bei der Bedieneinheit um ein Display, insbesondere ein Touchdisplay, ganz besonders bevorzugt ein OLED Touch Display. Über die Bedieneinheit können somit verschiedenste relevante Informationen direkt an dem Hardwaresystem abgelesen werden, ohne dass eine externe Auswerte- oder aber Kommunikationseinheit, beispielsweise ein Computer, angeschlossen werden muß. Ebenfalls ist es bei der Verwendung eines Touchdisplays möglich, das Hardwaresystem über die Bedieneinheit selber direkt zu bedienen. Über verschiedene Menüstrukturen können so die verschiedenen Module und hierüber wiederum die verschiedenen Einsteckmodule und die jeweils daran gekoppelten Funktionen bedient, gesteuert oder aber ausgelesen oder überwacht werden. Insbesondere bietet die integrierte Bedieneinheit bei mobilen Anwendungen den Vorteil, dass aufwendige weitere Eingabe- oder Bediengeräte entfallen.

Insbesondere ist das Hardwaresystem über das Display bedienbar, vorzugsweise sind die Einsteckmodule über das Display direkt ansteuerbar. Das Hardwaresystem weist weiterhin bevorzugt eine eigene Softwareumgebung auf, über die das gesamte Hardwaresystem bedienbar ist. Die Software des Hardwaresystems ist derart ausgebildet, dass sie sich beliebig modular über die Einsteckmodule erweitern lässt oder aber aufgrund einer Initialisierung bei Einstecken eines Einsteckmoduls selbständig erweitert, so dass das Einsteckmodul wiederum ansteuerbar ist.

Das Einsteckmodul selber weist wiederum eine eigene oder aber Zusatzsoftware auf, über die dann das an das Einsteckmodul angeschlossene Periepheriebauteil, beispielsweise ein Aktor, über das Display des Hardwaresystems ansteuerbar ist. Bevorzugt weist jedes Einsteckmodul einen Treiber für die Funktion des angeschlossenen Elements selber auf. Beispielsweise im Falle eines Aktors einen entsprechenden Treiber, um den Aktor zu bedienen, im Falle eines Sensors einen entsprechenden Treiber, um den Sensor auszulesen oder aber auch zu kalibrieren.

Sofern ein Fehler innerhalb des Hardwaresystems selber auftritt, ist eine damit verbundene Fehlermeldung über das Display durch den Bediener direkt ablesbar. Eine aufwendige Fehlersuche in einem Prüfstandsaufbau aufgrund falsch angeschlossener oder aber fehlerhafter Hardware oder Software entfällt somit bei dem erfindungsgemäßen Hardwaresystem ebenfalls.

Das Gehäuse des Hardwaresystems ist bevorzugt aus einem metallischen Werkstoff ausgebildet, insbesondere aus Leichtmetall, ganz besonders bevorzugt aus Aluminium. Das Gehäuse vereint somit verschiedene Eigenschaften zu einem Optimum, weshalb es mechanisch robust, elektrisch abschirmend sowie leicht ist. Das Hardwaresystem kann somit aufgrund seines Gewichts von mitunter nur wenigen Hundert Gramm leicht transportiert werden, ist bei mechanischen Einflüssen, die bei einem Prüfstandsaufbau oder während eines Tests in einem Prototypenfahrzeug auftreten können, hinreichend geschützt, so dass die darin befindliche Elektronik sowie die elektrischen Bauteile nicht beschädigt werden.

Bei einer modularen Erweiterung von mehr als einem Dutzend Zwischenmodulen wird durch das metallische Gehäuse eine ausreichende mechanische Stabilität sichergestellt. Insbesondere handelt es sich bei dem Gehäuse um Massivbauteile, insbesondere massive Fräsbauteile. Hierdurch wird die modulare Stapelbarkeit gegenüber Blechformbauteilen erleichtert sowie bei mehrjähriger Nutzung mit Hunderten von mechanischen Koppelungen der einzelnen Module untereinander die Robustheit den einzelnen Komponenten des Hardwaresystems eine ausreichende mechanische Stabilität gegeben, so dass diese auch unter widrigen und harten Nutzungsbedingungen einwandfrei einsetzbar sind.

Zwischen den einzelnen Modulen, also zwischen dem Grundmodul, dem Zwischenmodul und dem Deckelmodul oder aber zwischen mehreren Zwischenmodulen wird besonders bevorzugt eine Isolierungsschicht angeordnet, insbesondere aus einem Kunststoff oder Plastikwerkstoff, ganz besonders bevorzugt aus Plexiglas. Die Isolierungsschicht selber kann zur optischen Kenntlichmachung der einzelnen eingesetzten Zwischenmodule eingesetzt werden, indem verschiedene Farben bei dem Kunststoff oder Plastikwerkstoff verwendet werden. Im Falle des Einsatzes eines transparenten Plastikwerkstoffs, insbesondere von einem Plexiglas, ist es wiederum möglich, über in dem Hardwaresystem angeordnete Leuchtmittel, beispielsweise Leuchtdioden, verschiedene Betriebszustände direkt ablesbar anzuzeigen. Beispielsweise kann eine optische Rückmeldung des korrekten Einsteckens eines Einsteckmoduls über rot und grün dargestellt werden. Ebenfalls ist ein Fehler über eine beispielsweise rot grüne Darstellung direkt anzeigbar.

In einem Hardwaresystem, das mit mitunter mehr als 50 Einsteckmodulen versehen ist, kann der Bediener somit sofort erkennen, auf welcher Modulebene ein Fehler vorliegt und gegebenenfalls an welchem Einsteckmodul. Dabei ist die farbliche Signalgebung nicht auf die Farben rot grün begrenzt, sondern es kann das gesamte, für das menschliche Auge wahrnehmbare Farbspektrum eingesetzt werden, um verschiedene Betriebszustände oder aber Bereitschaftssignale optisch anzuzeigen. Ebenfalls kann im Rahmen der Erfindung die Isolierungsschicht über das Gehäuse überstehend ausgebildet werden, so dass die Isolierungsschicht die Einsteckmodule mit abdeckt. Hierdurch können eine elektrische sowie eine EMV-Isolierung der Einsteckmodule untereinander erfolgen. Ebenfalls können die Module untereinander mechanisch voneinander getrennt oder aber geschützt werden, so dass bei mechanischen ungewollten Einflüssen auf das Hardwaresystem ein Abknicken oder eine sonstige Beschädigung des eingesteckten Einsteckmoduls vermieden wird.

Im Rahmen der Erfindung kann zwischen den einzelnen Modulen jedoch auch eine leitende Schicht angeordnet werden, insbesondere wenn das Hardwaresystem in einem Hochspannungsbereich eingesetzt wird. Im Rahmen der Erfindung wäre es vorstellbar, dass das Hardwaresystem über das Gehäuse geerdet wird.

Weiterhin besonders bevorzugt sind die einzelnen Module über eine formschlüssige Koppelung miteinander lösbar verbunden. Insbesondere handelt es sich bei der formschlüssigen Koppelung um eine Schraubverbindung bzw. eine Schnellverbindung, wobei insbesondere die Schnellverbindung oder die Schraubverbindung nur zwischen einem Modul und dem benachbarten Modul ausgebildet ist. Hierdurch ist es möglich, die einzelne Schraubverbindung zwischen zwei Modulen zu lösen, so dass bei einem Hardwaresystem, das beispielsweise aus zehn Modulen in Sandwichbauweise aufgebaut ist, ein mittleres Modul entnehmbar ist, ohne dass das gesamte Hardwaresystem demontiert werden muss. Somit ist die Schraubverbindung des mittleren Moduls lösbar, das mittlere Modul entnehmbar und die verbleibenden Module sind wieder lösbar miteinander koppelbar. Die Schraubverbindung der verbleibenden Module sind somit wiederum miteinander koppelbar, so dass das Hardwaresystem bzw. das Gehäuse mechanisch robust und sicher lagefixiert miteinander verbunden ist.

Weiterhin besonders bevorzugt weist das Grundmodul und/oder das Deckelmodul und/oder die Zwischenmodule mindestens einen Einsteckplatz auf, vorzugsweise weist ein Zwischenmodul vier Einsteckplätze auf. Besonders bevorzugt ist ein Zwischenmodul derart aufgebaut, dass jeweils zwei Einsteckmodule nebeneinander angeordnet werden, wobei die anderen zwei Einsteckmodule auf einer gegenüberliegenden Seite des Zwischenmoduls einsteckbar sind und das Zwischenmodul spiegelsymmetrisch aufgebaut ist. Hierdurch ist es möglich, das Hardwaresystem insbesondere für Einsatzgebiete bereit zu stellen, die eine redundante Überwachung oder aber redundante Steuerung erfordern. Die jeweils auf den spiegelsymmetrischen Seiten gegenüberliegenden Einsteckmodule können zeitgleich über das Hardwaresystem angesteuert werden, wobei jeweils nur eine Rechenleistung benötigt wird, da die Signale parallel über die Zwischenebene an die zwei spiegelsymmetrisch angeordneten Einsteckmodule weitergegeben werden können. Ebenfalls erlaubt diese Anordnung einen besonders kompakten Aufbau sowie die Unterbringung möglichst vieler Einsteckmodule auf kleinem Raum.

Weiterhin bevorzugt sind zwei Hardwaresysteme miteinander koppelbar, die über jeweils einen Einsteckplatz miteinander koppelbar sind, wobei die Hardwaresysteme nebeneinander anordnenbar sind. Im Rahmen der Erfindung ist es auch möglich, zwei Hardwaresysteme über einen anderen Adapter, der beispielsweise im Austausch zu einem Deckelmodul modular auf die zwei Hardwaresysteme aufgesetzt wird, zu koppeln. Im Rahmen der Erfindung ist es ebenfalls vorstellbar, drei oder vier Hardwaresysteme, die einen jeweils schichtweisen bzw. turmartigen eigenen Aufbau besitzen, nebeneinander anzuordnen und miteinander zu koppeln.

Hierbei sind dann bevorzugt die mindestens zwei nebeneinander angeordneten Hardwaresysteme über jeweils das andere Hardwaresystem bedienbar. Die zwei nebeneinander angeordneten Hardwaresysteme sind derart miteinander kompatibel, dass sie als ein Gesamthardwaresystem ansteuerbar sind.

Besonders bevorzugt ist das Hardwaresystem mit einer externen Datenauswerteeinheit koppelbar, vorzugsweise mit einem Computer. Hierüber ist es möglich, das Hardwaresystem über den Computer zu bedienen und somit wiederum über das Hardwaresystem die an das Hardwaresystem angeschlossenen Sensoren und Aktoren oder sonstigen Peripheriebauteile über den Computer zu bedienen. Hierzu wird besonders bevorzugt ein Einsteckmodul in das Hardwaresystem eingesetzt, das die Schnittstelle zwischen externer Datenauswerteeinheit bzw. Computer und Hardwaresystem darstellt.

Zum korrekten Sitz der Einsteckmodule in dem Hardwaresystem selber sind diese weiterhin besonders bevorzugt arretierbar, insbesondere über eine Schnellverbindung. Bei der Schnellverbindung handelt es sich ganz besonders bevorzugt um eine Magnetverbindung. Die Magnetverbindung sorgt im Zusammenspiel mit dem Gehäuse des Hardwaresystems für eine schnelle Anschluss- bzw. Einschubmöglichkeit des Einsteckmoduls sowie einen festen Sitz. Bei Einstecken des Einschubmoduls wird dieses aufgrund der Magnetwirkung von dem Gehäuse angezogen, weshalb ein fehlerfreies und sicheres Einstecken des Einsteckmoduls in das Gehäuse des Hardwaresystems sichergestellt wird. Durch die Magnetkraft entsteht bei vollständigem Einstecken des Einsteckmoduls ein akustisches Bestätigungsgeräusch in Form eines Klackens. Dies gibt dem Bediener eine Rückmeldung, dass er das jeweilige Einsteckmodul korrekt in das Gehäuse eingesteckt hat.

Die Einsteckmodule selber weisen einen kartenartigen Einsteckbereich sowie einen Kopfbereich, wobei der Einsteckbereich im Wesentlichen vollständig in den Einsteckschacht des Gehäuses einsteckbar ist. In dem Kopfbereich des Einsteckmoduls sowie vorzugsweise in Teilen des Einsteckbereichs sind verschiedene Elektronikkomponenten untergebracht, die für den jeweiligen Anwendungsfall des Einsteckmoduls benötigt werden.

So ist beispielsweise bei einem Einsteckmodul für einen Aktuator im Kopfbereich ein Speicherbaustein angeordnet, auf dem eine Treibersoftware des Aktuators abgelegt ist. Ebenfalls kann in dem Kopfbereich eines Einsteckmoduls ein A/D-Wandler, aber auch ein Spannungswandler oder aber auch ein Potentiometer angeordnet sein. Erfindungsgemäß wird hierdurch ein Wärmeeintrag, der bei Regelung, Steuerung oder Auswertung der an das Hardwaresystem angeschlossenen Peripheriebauteile in dem Einsteckmodul entsteht, nicht in das Gehäuse des Hardwaresystems eingeleitet. Ebenfalls erfolgt die Wärmeentwicklung nicht im Inneren des Gehäuses des Hardwaresystems, weshalb auf aufwendige Verfahren sowie Mittel zum Kühlen des Hardwaresystems verzichtet werden kann. Hierdurch reduzieren sich die geometrischen Abmessungen des Hardwaresystems und ein Bauteilversagen in Form von Hitzeentwicklung wird vermieden.

Die zuvor genannten Eigenschaften bzw. Merkmale sind im Rahmen der Erfindung beliebig untereinander kombinierbar mit den sich damit ergebenden Vorteilen, ohne den Rahmen der Erfindung zu verlassen.

Weitere Vorteile, Merkmale, Eigenschaften und Aspekte der vorliegenden Erfindung sind Bestandteil der folgenden Beschreibung. Bevorzugte Ausführungsvarianten werden in den schematischen Figuren dargestellt. Diese dienen dem einfachen Verständnis der Erfindung. Es zeigen:
- Figur 1: ein erfindungsgemäßes Hardwaresystem mit Zwischenmodul in Explosivdarstellung;
- Figur 2a und b: das Hardwaresystem in Zusammenbauweise;
- Figur 3a bis d: das Deckelmodul in verschiedenen Ansichten;
- Figur 4a bis d: das Zwischenmodul in verschiedenen Ansichten;
- Figur 5a bis d: das Grundmodul in verschiedenen Ansichten;
- Figur 6a und b: die Zwischenschicht in verschiedenen Ansichten;

- Figur 7a bis d: das Einsteckmodul in verschiedenen Ansichten;
- Figur 8: die zentrale Spannungsversorgung;
- Figur 9: eine Spannungsverteilung in einem Zwischenmodul;
- Figur 10: eine Datenkommunikation zwischen einem Modul, Einsteckmodul und einem an das Einsteckmodul angeschlossenen externen Element;
- Figur 11: einen spiegelsymmetrischen Aufbau eines Zwischenmoduls mit vier Einsteckmodulen;
- Figur 12: ein Schema der Autoadressierung;
- Figur 13: eine schematische Darstellung des Pfostenfeldsteckers der einzelnen Modulebenen;
- Figur 14: eine Autoadressierung auf einer Modulebene und
- Figur 15: eine Elektronikplatine zur Anordnung in einem erfindungsgemäßen Gehäuse.

In den Figuren werden für gleiche oder ähnliche Bauteile aus Vereinfachungsgründen dieselben Bezugszeichen verwendet, auch wenn eine wiederholte Beschreibung aus Vereinfachungsgründen entfällt.

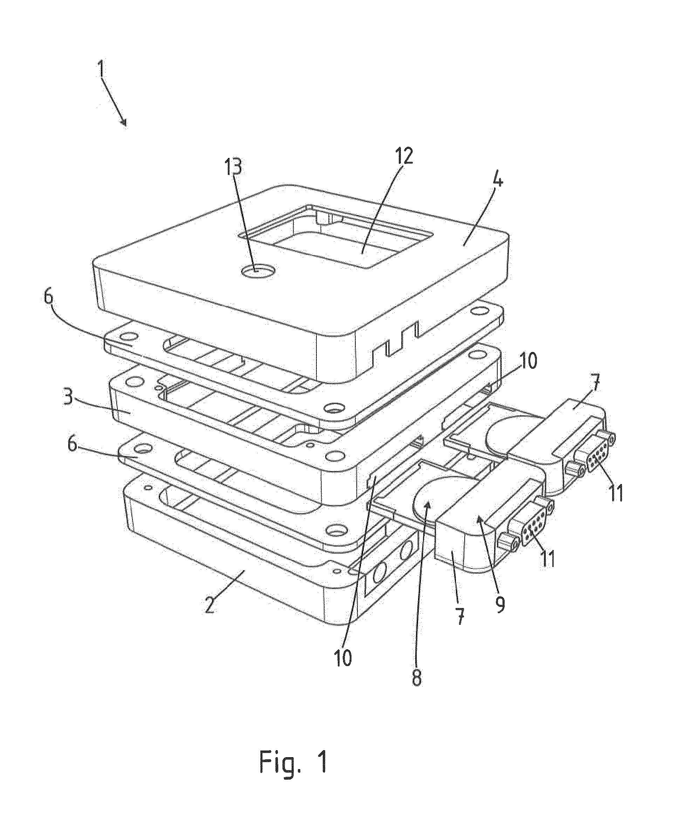

Figur 1 zeigt das erfindungsgemäße modular konfigurierbare Hardwaresystem 1 in einer Explosivdarstellung. Das Hardwaresystem 1 weist ein Grundmodul 2, ein Zwischenmodul 3 sowie ein Deckelmodul 4 auf. Im Rahmen der Erfindung ist es möglich, zwei, drei, vier oder aber beliebig viele, technisch sinnvolle, Zwischenmodule 3 zwischen dem Grundmodul 2 und dem Deckelmodul 4 anzuordnen. So ist es beispielsweise im Rahmen der Erfindung möglich, bis zu 50 oder sogar 60 Zwischenmodule 3 zwischen Grundmodul 2 und Deckelmodul 4 anzuordnen. In der Regel sollten als Haupteinsatzzweck zwischen zwei und elf Zwischenmodule 3 zwischen dem Grundmodul 2 und dem Deckelmodul 4 angeordnet werden. Die einzelnen Module 2, 3, 4 bilden dabei jeweils eine Modulebene 5. Die einzelnen Modulebenen 5 sind untereinander von einer jeweiligen Zwischenschicht 6 getrennt. Bei der Zwischenschicht 6 kann es sich dabei um eine Isolierungsschicht oder aber auch eine Zwischenschicht 6 aus einem metallischen Material handeln.

In das Hardwaresystem 1 sind weiterhin Einsteckmodule 7 lösbar einsteckbar. Die Einsteckmodule 7 weisen selber wiederum einen Kartenabschnitt 8 sowie einen Modulabschnitt 9 auf. Der Kartenabschnitt 8 ist dabei vollständig in eine Einstecköffnung 10 des Hardwaresystems 1, hier dargestellt in eine Einstecköffnung 10 des Zwischenmoduls 3, einsteckbar. Der Modulabschnitt 9 des Einsteckmoduls 7 steht dann gegenüber dem Hardwaresystem 1 über. Jedes Einsteckmodul 7 weist wiederum einen Stecker 11 auf, an dem dann, hier nicht näher dargestellte Sensoren, Aktoren oder aber auch Datennetze ansteckbar sind.

Das Deckelmodul 4 des Hardwaresystems 1 weist ferner ein Display 12 auf, über das Bestdatenbetriebszustände oder sonstige Informationen anzeigbar sind. Ferner ist das Display 12 als Touchdisplay ausgebildet, so dass sich das Hardwaresystem 1 auch über das Display 12 selbst bedienen lässt. In dem Deckelmodul 4 ist weiterhin ein zentraler Taster 13 angeordnet, dessen Funktion im Rahmen der Erfindung wiederum frei programmierbar ist. Es bietet sich an, den zentralen Taster 13 für einen Powerdownmodus, also einen Taster 13, um das Hardwaresystem, 1 in einen Bereitschaftszustand oder aber in einen Sleepzustand zu versetzen.

Nachfolgende Figuren sind nicht maßstabsgetreu. Das Hardwaresystem kann quadratisch oder auch rechteckförmig konfiguriert sein.

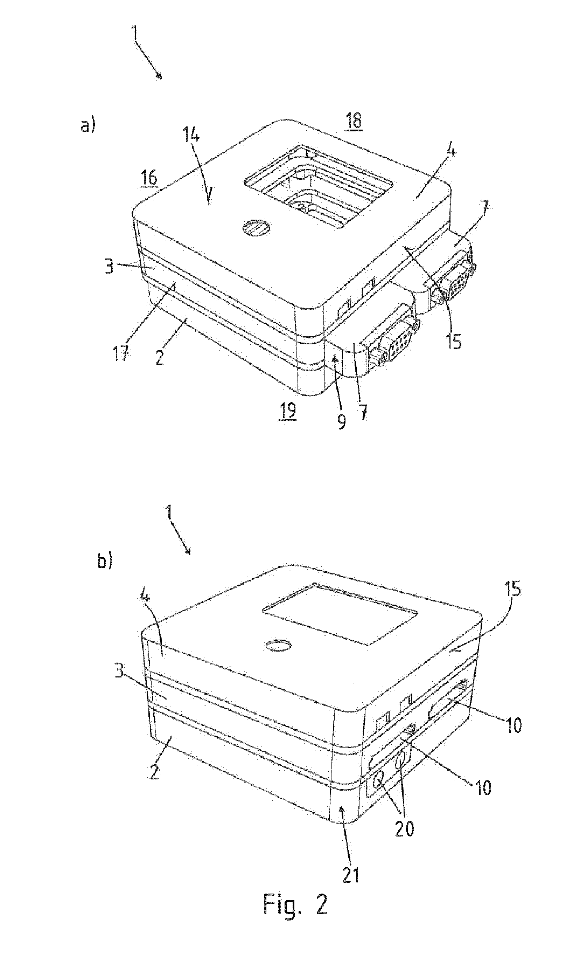

Figur 2a und b zeigen das erfindungsgemäße Hardwaresystem 1 in Zusammenbauweise, ebenfalls bestehend aus einem Grundmodul 2, Zwischenmodul 3 sowie einem Deckelmodul 4. Zwischen den einzelnen Modulen sind wiederum Zwischenschichten 6 angeordnet, die eine Trennung der Modulebenen 5 untereinander ermöglichen. Gut zu erkennen ist, dass das Hardwaresystem 1 eine kastenförmige Konfiguration aufweist. Die Oberseite 14 wird dabei von dem Deckelmodul 4 gebildet. Ebenfalls in Figur 2a ist dargestellt, dass die Einsteckmodule 7 in das Zwischenmodul 3 an einer vorderen Einsteckseite 15 nebeneinander eingesteckt sind. An einer nicht näher dargestellten hinteren Einsteckseite 16 ist es ebenfalls möglich, zwei Einsteckmodule 7 in das Zwischenmodul 3 einzustecken. Demgegenüber verbleiben eine auf die Bildebene bezogene vordere Seitenwand 17 sowie eine hintere Seitenwand 18. Die Seitenwände 17, 18 selber sowie die Einsteckseiten 15, 16 bilden dabei die seitlichen Wände des Gehäuses. Die Oberseite 14 wird durch das Deckelmodul 4 mit ausgebildet sowie die nicht näher dargestellte Unterseite 19 durch das Grundmodul 2. Die Einsteckmodule 7 selbst kommen dabei mit dem Modulabschnitt 9 an der vorderen Einsteckseite15 zur Anlage. Der Modulabschnitt 9 selber steht gegenüber der vorderen Einsteckseite 15 über. Das Hardwaresystem in Figur 2a ist ohne elektronisches Innenleben, also nur als leeres Gehäuse dargestellt.

In Figur 2b dargestellt ist das zusammengebaute Hardwaresystem 1 ohne Einsteckmodule 7. Zu erkennen sind die zwei Einsteckschächte 10 in der vorderen Einsteckseite 15 auf Höhe des Zwischenmoduls 3. Ebenfalls zu erkennen ist ein Spannungsanschluss 20 in dem Grundmodul 2 zum Anschluss von hier nicht näher dargestellten Spannungsversorgungsleitungen. Ferner weist die kastenförmige Gehäusekonfiguration abgerundete Ecken 21 auf, die einen Übergang von der vorderen Einsteckseite 15 zu der hinteren Seitenwand 18 und von der hinteren Seitenwand 18 zu der hinteren Einsteckseite 16 ermöglichen. Hierdurch wird die Handhabung des Hardwaresystems 1 vereinfacht sowie das Verletzungsrisiko eines Bedieners verringert.

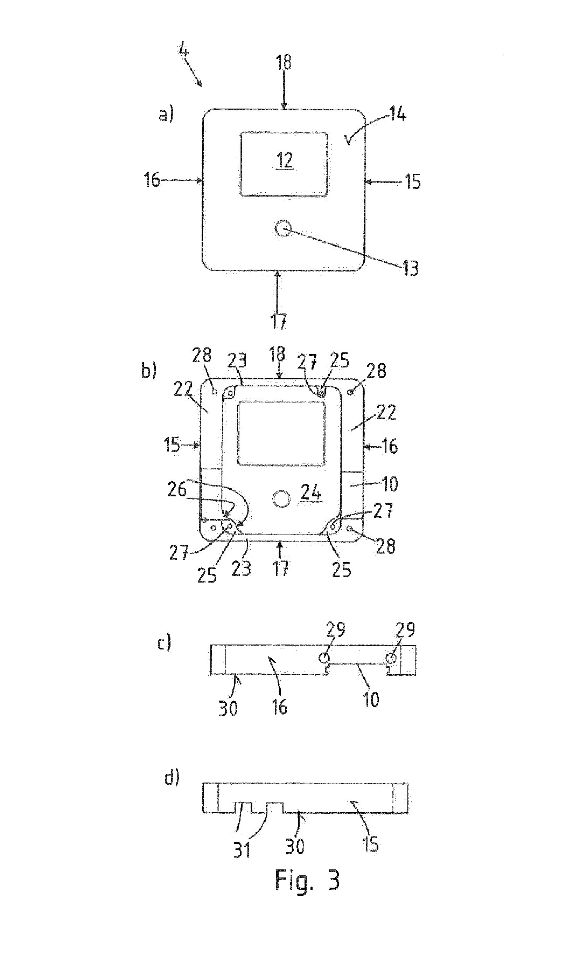

Figur 3a bis d zeigen ein Deckelmodul 4 in einer Draufsicht, Unteransicht sowie einer jeweiligen Seitenansicht der vorderen 15 und hinteren Einsteckseite 16. In Figur 3a ist eine Draufsicht auf die Oberseite 14 des Deckelmoduls 4 gezeigt. Das Deckelmodul 4 weist eine im Wesentlichen quadratische Konfiguration auf, wobei in die Oberseite 14 das Display 12 sowie ein Taster 13 eingelassen sind.

In Figur 3b ist dargestellt, dass an der vorderen Einsteckseite 15 sowie an der hinteren Einsteckseite 16 eine jeweils dickere Gehäusewandung 22 ausgebildet ist, in Relation zu der Gehäusewandung 23 der vorderen 17 und hinteren Seitenwand 18. Im Inneren des Deckelmoduls 4 ist eine Ausnehmung 24 ausgebildet, sodass das Deckelmodul 4 von innen hohl ist. Es ist somit möglich, eine nicht näher dargestellte Platine in dem Deckelmodul 4 mit entsprechend auf der Platine angeordneten Elektronikkomponenten zu platzieren.

Weiterhin sind in der Ausnehmung 24 Montagesockel 25 vorhanden, wobei die Montagesockel 25 dazu dienen, die nicht näher dargestellte Platine aufzunehmen. Die dargestellten Rundungen 26 bzw. Radien entstehen durch eine Herstellung des Deckelmoduls 4 in Fräsbauweise. Hierdurch wird es ermöglicht, den zur Verfügung stehenden Bauraum optimal auszunutzen, bei gleichzeitiger günstiger Herstellung durch Verwendung entsprechender spanabhebender Fräsmittel. In den Montagesockeln 25 sind Montagelöcher 27 angeordnet, so dass die nicht näher dargestellte Platine in den Montagelöchern 27 steckbar und/oder schraubbar ist. Ferner sind in den Gehäusewandungen 22, 23 ebenfalls Montagelöcher 28 angeordnet, mit denen es möglich ist, die einzelnen Modulebenen 5 miteinander zu koppeln.

Figur 3c zeigt eine Ansicht der hinteren Einsteckseite 16, wobei, wie hier dargestellt, ein Einsteckschacht in dem Deckelmodul 4 angeordnet ist. Auf die Bildebene bezogen oberhalb des Einsteckschachtes 10 sind Magnete 29 angeordnet, wobei die Magnete 29 dazu dienen, mit dem hier nicht näher dargestellten Magneten eines Einsteckmoduls 7 eine formschlüssige magnetische Verbindung herzustellen. Hierdurch wird sichergestellt, dass das Einsteckmodul 7 lösbar ordnungsgemäß in den Einsteckschacht eingesteckt wird und durch die magnetische Verbindung gehalten wird und das beim Einstecken entstehende Klackgeräusch dem Bediener dieses auch zu erkennen gibt. Das eingesteckte Einsteckmodul 7 wird durch die magnetische Verbindung arretiert, so dass es nicht unbeabsichtigt bzw. ungewollt aus dem Gehäuse entfernt wird bzw. aus diesem herausfällt.

Ferner ist der Einsteckschacht 10 durchgängig auf die Oberfläche der Montageunterseite 30 des Deckelmoduls 4 ausgebildet. Dies bedingt eine besonders kostengünstige Fertigungsmöglichkeit, da mit einem spanabhebenden Fräswerkzeug direkt der Einsteckschacht 10 mit ausgebildet werden kann.

Figur 3d zeigt die vordere Einsteckseite 15 des Deckelmoduls 4, wobei hier zwei Stecköffnungen 31 angeordnet sind, wobei nur die Stecköffnungen 31 weitere, nicht näher dargestellte oder beschriebene Steckverbindungen einsteckbar sind.

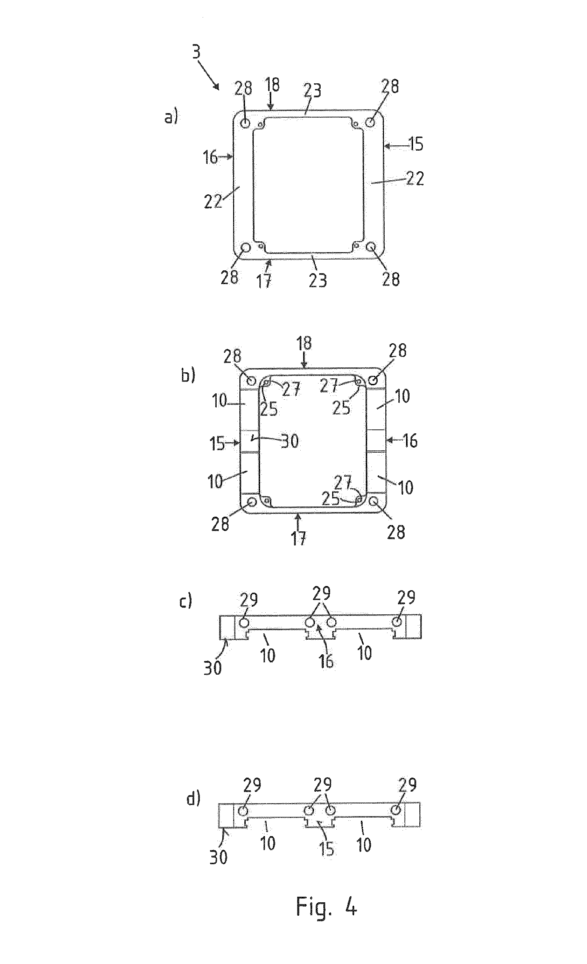

Figur 4a bis d zeigen weiterhin eine Draufsicht, eine Hinteransicht sowie jeweils eine Seitenansicht der vorderen Einsteckseite 15 und der hinteren Einsteckseite 16 eines Zwischenmoduls 3. Auch bei dem Zwischenmodul 3 ist gemäß Figur 4a und b zu erkennen, dass die Gehäusewandung 22 der vorderen Einsteckseite 15 und der hinteren Einsteckseite 16 größer ausgebildet ist, als die Gehäusewandung 23 der vorderen Seitenwand 17 und der hinteren Seitenwand 18. Insbesondere im Bereich der Einsteckschächte 10 bietet die breitere Gehäusewandung 22 der vorderen Einsteckseite 15 sowie der hinteren Einsteckseite 16 eine bessere Abstützmöglichkeit für die hier nicht näher dargestellten Einsteckmodule 7. Der nicht näher dargestellte Kartenabschnitt 8 des Einsteckmoduls 7 wird durch die breite Gehäusewand 22 der vorderen Einsteckseite 15 und/oder der hinteren Einsteckseite 16 abgestützt.

Das Zwischenmodul 3 ist im Inneren vollständig ausgehüllt. Auch hier kann wiederum eine nicht näher dargestellte Elektronikplatine angeordnet werden. Dazu weist das Zwischenmodul 3 ebenfalls Montagesockel 25 auf, wobei die Montagesockel 25 ebenfalls Montagelöcher 27 aufweisen, um die nicht näher dargestellte Elektronikplatine festzuschrauben. Weiterhin sind Montagelöcher 28 in den Ecken der Gehäusewandungen 22, 23 dargestellt, so dass mehrere Zwischenmodule 3 bzw. das Deckelmodul 4 und/oder das Grundmodul 2 an dem Zwischenmodul 3 steckbar und/oder verschraubbar sind.

Weiterhin ersichtlich ist in Figur 4c und d, die jeweils die vordere Einsteckseite 15 bzw. hintere Einsteckseite 16 darstellen, dass das Zwischenmodul 3 spiegelsymmetrisch aufgebaut ist. Hierdurch wird es ermöglicht, vier Einsteckmodule 7 in ein Zwischenmodul 3 einzustecken. Auch sind die Einsteckschächte 10 in dem Zwischenmodul 3 derart ausgebildet, dass sie in eine Montageunterseite 30 des Zwischenmoduls 3 übergehen. Auch hierdurch ergibt sich wiederum der Vorteil einer besonders kostengünstigen Fertigung. Auch sind an der vorderen Einsteckseite 15 und an der hinteren Einsteckseite 16 Magnete 29 angeordnet, wobei die Magnete 29 wiederum mit an den hier nicht näher dargestellten Einsteckmodulen 7 angeordneten Magneten eine formschlüssige magnetische Verbindung eingehen.

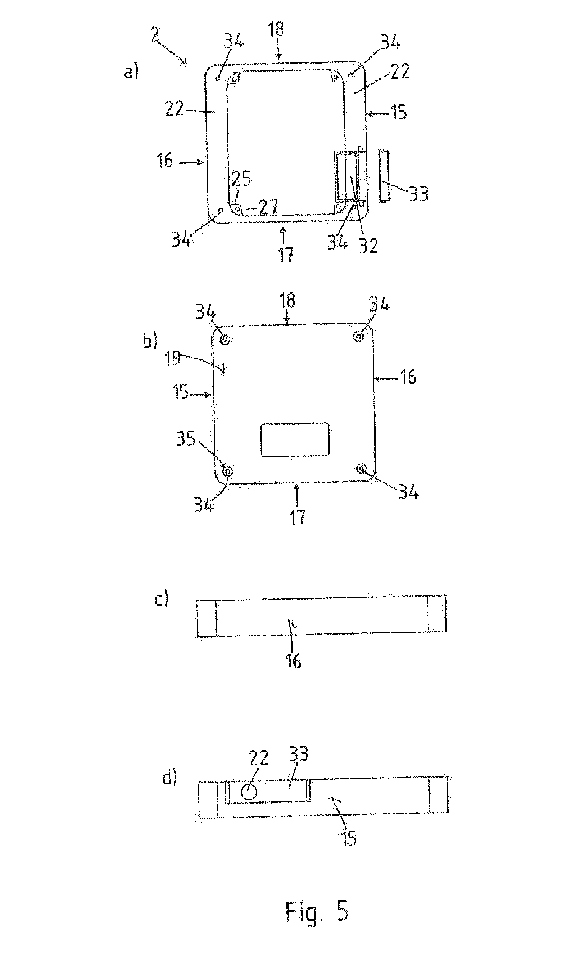

Weiterhin dargestellt sind in Figur 5a bis d eine Draufsicht, eine Unteransicht sowie eine Ansicht der vorderen Einsteckseite 15 und der hinteren Einsteckseite 16 des Grundmoduls 2.

Figur 5a zeigt eine Draufsicht auf das Grundmodul 2, wobei auch hier die Gehäusewandung 22 der vorderen Einsteckseite 15 und der hinteren Einsteckseite 16 gegenüber der Gehäusewandung 23 der vorderen Seitenwand 17 und der hinteren Seitenwand 18 dicker ausgebildet ist. Weiterhin dargestellt ist eine Öffnung 32 für den Spannungsanschluss 20, wobei in die Öffnung 32 ein Adapterstück 33 einsetzbar ist. Das Grundmodul 2 weist die Unterseite 19 des Hardwaresystems 1 gemäß Figur 5b auf. Eingezeichnet sind hier vier Schraubverbindungen 34, die es ermöglichen, das gesamte Hardwaresystem 1 miteinander zu koppeln. Ebenfalls kann im Bereich der Schraubverbindung 34 jeweils ein Fuß 35 angeordnet sein, welcher beispielsweise ein Gummifuß sein kann, sodass das Hardwaresystem 1 sicher und rutschfest auf einen Untergrund stellbar ist. Weiterhin sind in Figur 5a ebenfalls Montagesockel 25 zur Anordnung eine nicht näher dargestellten Grundplatine im Inneren des Grundmoduls vorgesehen. Auch die Montagesockel 25 weisen wiederum Montagelöcher 25 zur Kopplung der Grundplatine mit dem Grundmodul 2 auf. Die Grundplatine kann im Rahmen der Erfindung auch in dem Deckelmodul 4 angeordnet werden, so dass durch das Grundmodul 2 eine Spannungsversorgung des Hardwaresystems 1 hergestellt wird.

Figur 5c und d zeigen jeweils eine Seitenansicht, wobei in Figur 5d eine Seitenansicht der vorderen Einsteckseite 15 und der hinteren Einsteckseite 16, in Figur 5c gezeigt ist. In Figur 5d ist das Adapterstück 33 in der Öffnung 20 angeordnet ist und das Adapterstück 33 weist einen Spannungsanschluss 20 auf. In der Regel sind dies 12 Volt.

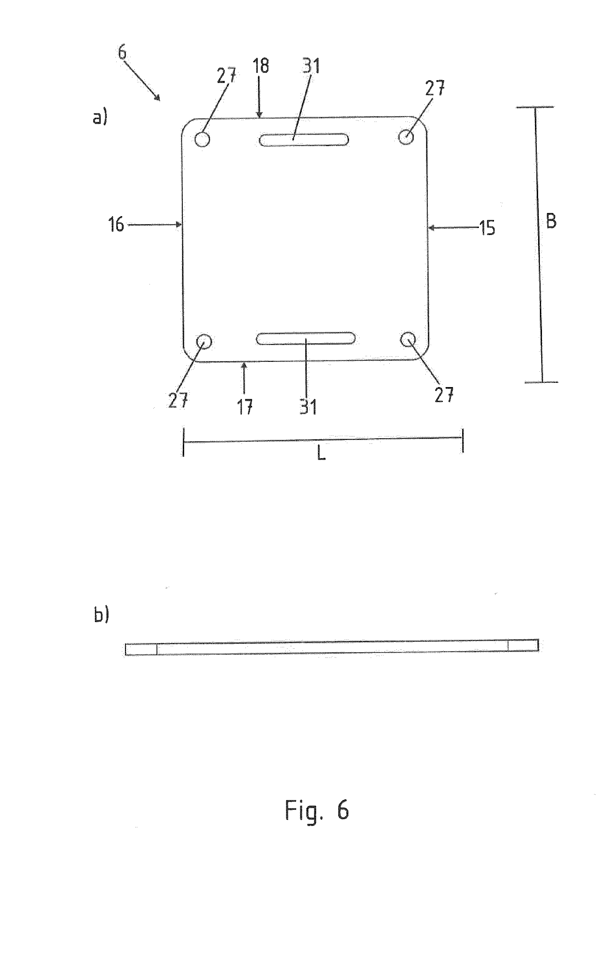

In Figur 6a und b ist eine Zwischenschicht 6 in einer Draufsicht sowie in einer Seitenansicht gezeigt. Die Zwischenschicht 6 dient als Isolator und/oder Abstandhalter zwischen den einzustellenden Modulen. Auch die Zwischenschicht 6 weist Montagelöcher 27 zur Durchführung hier nicht näher dargestellter Montagemittel, die zur Kopplung der einzelnen Module eingesetzt werden, auf. In der hier gezeigten Ausführungsvariante ist die Zwischenschicht 6 massiv ausgebildet, d. h. sie schottet die einzelnen Modulebenen 5 voneinander physisch ab.

Damit die Platinen der jeweiligen Module miteinander kommunizieren können, sowie mit Strom versorgt werden, weist die Zwischenschicht 6 Steckeröffnungen 31 auf, wobei durch die Steckeröffnungen 31 mehrpolige Pfostenfeldstecker 65 zum Datenaustausch und/oder zur Spannungsversorgung der einzelnen Platinen der Module ausgebildet sind. Die Steckeröffnungen 31 sind dabei im Bereich der Gehäusewandung 23 der vorderen Seitenwand 17 sowie der hinteren Seitwand 18 angeordnet. Die hier nicht näher dargestellten Pfostenfeldstecker 65 ermöglichen es also, die Einsteckmodule 7 mit dem Kartenabschnitt jeweils vollständig in das Modul einzuführen und somit an den nicht näher dargestellten Pfostenfeldsteckern 65 vorbeizuführen. Die Zwischenschicht 6 ist in ihrer Länge L und Breite B den einzelnen Modulen der Figuren 3, 4 und 5 entsprechend ausgebildet. Insbesondere in der Länge L ist es jedoch möglich, dass die Zwischenschicht 6 gegenüber den Modulen übersteht, so dass sie auch den Modulabschnitt des Einsteckmoduls 7 zumindest teilweise überdeckt.

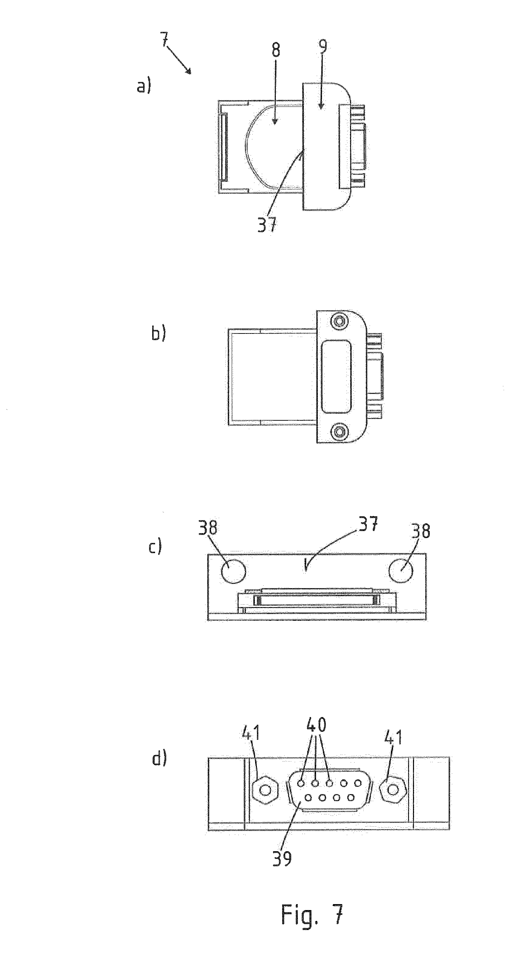

Figur 7a bis d zeigen ein Einsteckmodul 7 in einer Draufsicht, in einer Unteransicht sowie in einer Vorder- und einer Rückansicht. In Figur 7a und b ist die Einteilung des Einsteckmoduls 7 ein Kartenabschnitt 8 und Modulabschnitt 9 zu erkennen. Der Kartenabschnitt 8 wird dabei vollständig in das nicht näher dargestellte Hardwaresystem 1 eingesteckt, so dass der Modulabschnitt 9 formschlüssig mit einer Anlagefläche 37 an der vorderen 15 bzw. hinteren Einsteckseite 16 des Hardwaresystems 1 zur Anlage kommt.

Im Modulabschnitt 9 selber ist dann eine entsprechende Hardware für den Anschluss eines nicht näher dargestellten externen Elements, beispielsweise eines Senors oder aber auch eines Aktors unterbringbar. Hierdurch ergibt sich erfindungsgemäß der Vorteil, dass ein Wärmeeintrag in das Hardwaresystem 1 selber vermieden wird, da die elektrischen Bauteile außerhalb des Hardwaresystemsm 1 selber untergebracht sind.

In Figur 7c ist dargestellt, dass der Modulabschnitt mit einer Anlagefläche 37 an dem Hardwaresystem 1, genauer an der vorderen Einsteckseite 15 oder an der hinteren Einsteckseite 16 zur Anlage kommt. In die Anlagefläche 37 eingelassen sind Einsteckmodulmagneten 38, die mit dem Magneten 29 des Hardwaresystems 1 eine magnetische Verbindung eingehen und somit ein vollständiges Einrasten sowie einen festen Sitz der Einsteckmodule 7 in dem Hardwaresystem 1 sicherstellen.

In Figur 7d ist eine mögliche Anschlussmöglichkeit eines nicht näher dargestellten Sensors, Aktors oder Ähnlichem an das Einsteckmodul 7 in Form eines D-Sub-Steckers 39 dargestellt. Der D-Sub-Stecker 39 selber besteht dabei aus neun Polen 40 sowie zwei Sicherungsschrauben 41. Im Rahmen der Erfindung ist es aber beispielsweise auch vorstellbar, andere Steckverbindungen einzusetzen, beispielsweise Ethernetsteckverbindungen oder aber auch nur einen zweipoligen Stecker.

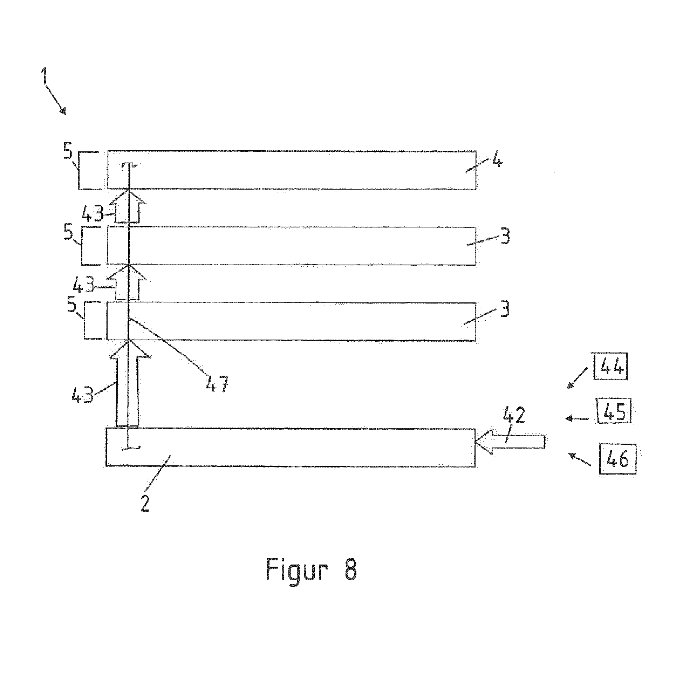

Figur 8 zeigt die Spannungsversorgung des Hardwaresystems 1, wobei hier dargestellt eine externe Versorgungsspannung 42 in das Grundmodul 2 beigebracht wird, und die externe Versorgungsspannung 42 von dem Grundmodul 2 aus auf die einzelnen Modulebenen 5 weitergeleitet wird. Die externe Versorgungsspannung 42 wird also von dem Grundmodul 2 als interne Versorgungsspannung 43 direkt weitergeleitet. Bevorzugt ist die externe Versorgungsspannung 42 gleich der internen Versorgungsspannung 43 gleich im Wesentlichen 12 Volt. Der Aufbau des Hardwaresystems 1 kann in der in Figur 8 dargestellten Konfiguration derart ausgebildet sein, dass das Deckelmodul 4 als Master fungiert und die Zwischenmodule 3 als Slave. Das Grundmodul 2 hat dann eine ausschließlich abschließende Funktion des Gehäuses sowie eine Weiterleitung der Versorgungsspannung 42.

Die Versorgungsspannung selber kann von einem Netzteil 44, von einem Akkumulator 45 oder aber auch von einem Kraftfahrzeugbordnetz 46 in das Grundmodul 2 eingespeist werden. Ebenfalls ist es vorstellbar, dass das Grundmodul 2 selber als Akkumulator 45 ausgebildet ist, also im Inneren des Grundmoduls 2 ein entsprechender Akkumulator 45 bzw. Akkumulatorzellen angeordnet sind. Im Rahmen der Erfindung verfügt das Hardwaresystem 1 über eine modular erweiterbare, physisch direkt gekoppelte Versorgungsleitung 47, die durch das gesamte Hardwaresystem 1 ausgebildet ist. Die Versorgungsleitung 47 ist mindesten einadrig, bevorzugt zwei- oder aber auch dreiadrig ausgebildet. Ebenfalls ist es im Rahmen der Erfindung vorstellbar, die Versorgungsleitung 47 redundant spiegelsymmetrisch bzw. mit einem nicht näher dargestellten Pfostenfeldstecker 65 ebenfalls redundant auszubilden. Das Hardwaresystem 1 verfügt somit über eine zentrale Spannungsversorgung.

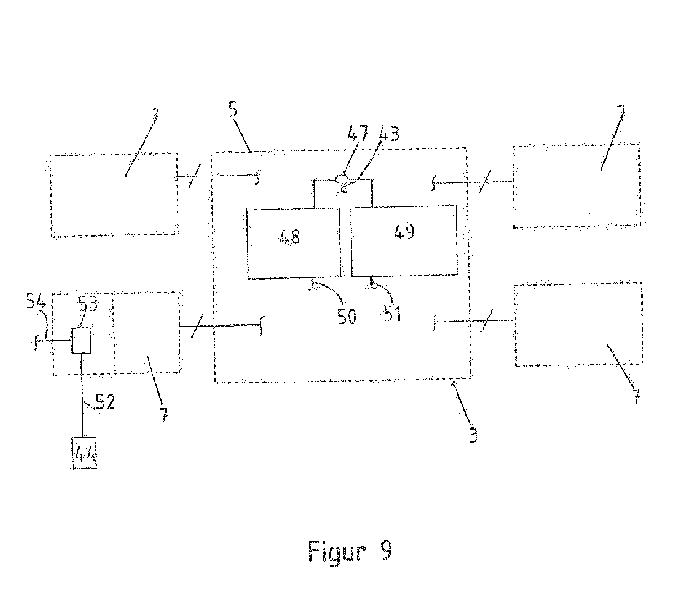

Figur 9 zeigt die Spannungsverteilung in einem Zwischenmodul 3. Hier ist zum einen die interne Versorgungsspannung 43 direkt von der Versorgungsleitung 47 abgreifbar und auf dem Modul direkt als interne Versorgungsspannung 43 weiterleitbar. Die interne Versorgungsspannung 43 ist jedoch auch im Rahmen der Erfindung von der Versorgungsleitung 47 abgreifbar und an einen jeweiligen Spannungswandler weiterleitbar. Hier dargestellt sind bevorzugt ein Spannungswandler 48, der eine Spannung 50 von 5 Volt und ein Spannungswandler 49, der eine Spannung 51 von 3,3 Volt wandelt. Von den Spannungswandlern 48, 49 sind dann Modulebenenspannungen in Höhe von 5 Volt 50 und Modulebenenspannungen in Höhe von 3,3 Volt 51 abgreifbar. Die drei verschiedenen Spannungsarten, also die interne Versorgungsspannung 43, die Modulebenenspannungen 5 Volt 50 und die Modulebenenspannungen 3,3 Volt 51 sind dann von jedem Einsteckmodul 7 auf der Modulebene 5 abgreifbar bzw. an das jeweilige Einsteckmodul 7 weiterleitbar. Bei den Spannungswandlern 48, 49 handelt es sich bevorzugt um getaktete Spannungsregler, um den Wärmeeintrag in dem System auch bei hoher Anzahl von Modulebenen 5 so gering wie möglich zu halten. Die Spannungswandler 48, 49 sind derart ausgelegt, dass sie eine Modulebene 5 mit vier Einsteckmodulen 7 und ausreichender Reserve mit der benötigten Spannung versorgen können.

Im Rahmen der Erfindung ist es weiterhin vorstellbar, dass insbesondere höhere Lastströme 54 geschaltet werden müssen. Bei Aktoren, die selbst nicht von einer externen Spannungsquelle, sondern von der Regelungs- bzw. Steuerungseinheit mit Spannung versorgt wird, ist dies insbesondere erforderlich. Hierbei wird wiederum von einem entsprechenden Netzteil 44, welches das gleiche Netzteil 44 der Versorgungsspannung 43 des Hardwaresystems 1 oder aber auch ein hiervon verschiedenes Netzteil sein kann, eine Lastversorgungsspannung 52 abgreifbar, die dann durch einen Leistungstreiber 53 derart geregelt wird, dass ein Laststrom 54 an ein hier nicht näher dargestelltes externes Element 58, beispielsweise einen Motortreiber, weitergegeben wird. Da sich der Leistungstreiber 53 selbst wiederum nicht innerhalb des Hardwaresystems 1 befindet, sondern bevorzugt in dem Einsteckmodul 7, erfolgt somit auch kein Wärmeeintrag in das Hardwaresystem 1 selber.

Durch die in Figur 8 und Figur 9 gezeigte zentrale Spannungsversorgung ist es somit möglich, eine zentrale interne Versorgungsspannung 43 innerhalb der Ebenen weiterzugeben. Auf einer jeweiligen Modulebene 5 wird die interne Versorgungsspannung 43 über mindestens einen getakteten Spannungswandler 48, 49 entsprechend in eine dort benötigte Spannung gewandelt. Ebenfalls ist es möglich, auf der Modulebene 5 die interne Versorgungsspannung 43 direkt abzugreifen. über die so bereitgestellten verschiedenen Spannungen auf der Modulebene 5 ist es möglich, die diskreten Bausteine sowie die Einsteckmodule 7 und deren Bausteine mit Spannung zu versorgen. Durch diese dezentrale Anordnung der einzelnen Spannungswandler 48, 49 pro Ebene ist es erfindungsgemäß möglich, das Hardwaresystem 1 beliebig modular zu erweitern, also zu konfigurieren. Insbesondere ist es möglich, ohne Modifikation einer zentralen Spannungsversorgung sowie einer Erhöhung der Redundanz das Hardwaresystem 1 beliebig wachsen zu lassen, da die jeweilige Redundanz bzw. Spannungsversorgung auf einer Modulebene 5 erfolgt.

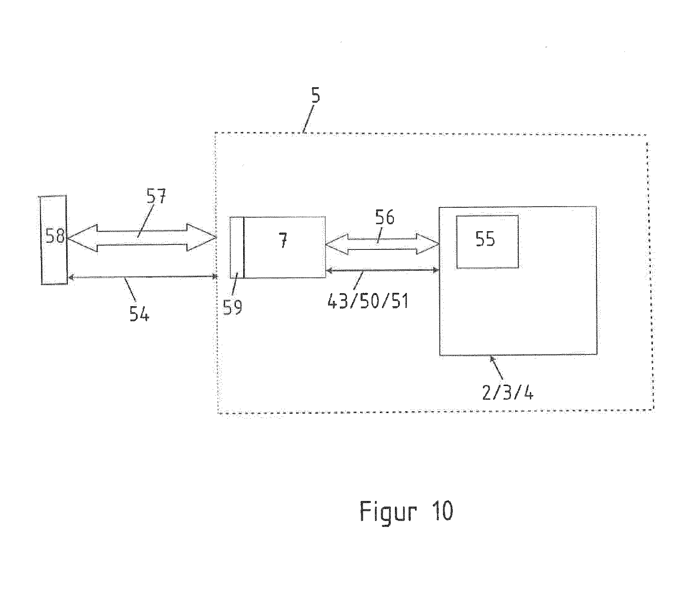

Figur 10 zeigt die Datenkommunikation sowie die Spannungsversorgung auf einer jeweiligen Modulebene 5. Hierbei ist das Grundmodul 2 oder das Zwischenmodul 3 oder das Deckelmodul 4 mit einem Controller 55 ausgestattet, der je nach Konfiguration des Hardwaresystems 1 ein Mastercontroller oder aber ein Slavecontroller sein kann. Der Controller 55 kommuniziert dabei über einen Datentransfer 56 mit dem in das jeweilige Modul 2/3/4 eingesteckten Einsteckmodul 7. Der Datentransfer 56 kann dabei ein ebeninternes Datenprotokoll oder aber auch ein zentrales Datenprotokoll des gesamten Hardwaresystems 1 verwenden. Ebenfalls erfolgt eine Spannungsversorgung von dem Modul 2/3/4 zu dem Einsteckmodul 7, dass eine interne Versorgungsspannung 43, eine Modulebenenspannung 5 Volt 50 oder aber auch eine Modulebenenspannung 3,3 Volt 51 sein kann.

Von dem Einsteckmodul 7 aus wird dann die Systemgrenze des Hardwaresystems 1 verlassen und es erfolgt ein externer Datentransfer 57 mit einem an das Einsteckmodul 7 gekoppelten externen Element 58. Das externe Element 58 kann auch von dem Einsteckmodul 7 optional mit einem entsprechenden Laststrom 54 versorgt werden. Das Einsteckmodul 7 und das externe Element 58 nutzen zum externen Datentransfer 57 insbesondere das Datenprotokoll des externen Elements 58. In dem Einsteckmodul 7 selber sind bevorzugt sowohl Treiberhardware als auch Treibersoftware zum Betreiben oder zur Kommunikation mit dem externen Element 58 vorgesehen.

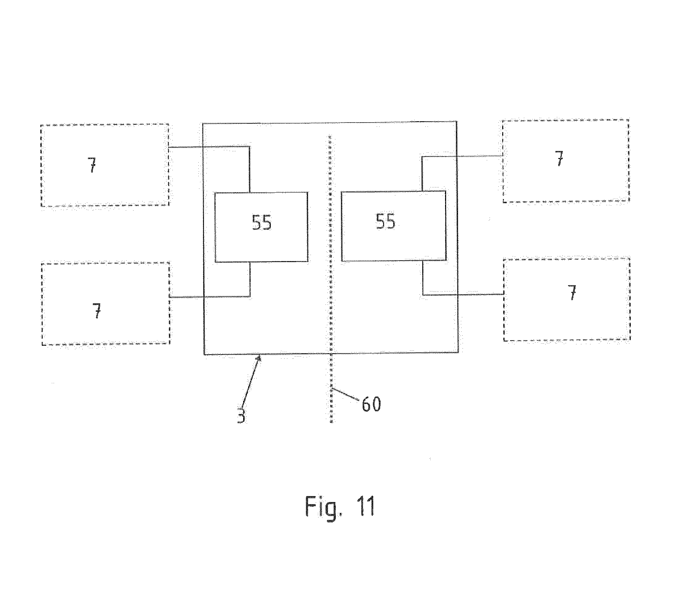

Figur 11 zeigt eine schematische Ansicht des spiegelsymmetrischen Aufbaus eines Zwischemoduls 3. An einer mittigen Spiegelebene 60 ist das Zwischenmodul 3 gespiegelt. Das Zwischenmodul 3 weist hierzu zwei Controller 55 auf, wobei jeder Controller 55 zwei Einsteckmodule 7 verwaltet. Im Rahmen der Erfindung ist es hierüber möglich, über ein Zwischenmodul 3 einen Programmablauf z. B. während eines Testzyklus, spiegelsymmetrisch parallel ablaufen zu lassen, wobei bei Ausfall einer Seite, die spiegelsymmetrische Seite dies redundant auffängt. Die Ausfallsicherheit kann beispielsweise dadurch noch weiter gesteigert werden, dass zwei Zwischenmodule 3 gespiegelt werden. Somit kann auf vier Controllern 55 der gleiche Programmablauf gefahren werden.

In besonders bevorzugter Ausführungsvariate ist jeder Controller 55 durch mindestens zwei Prozessoren, insbesondere drei, besonders bevorzugt vier, ganz besonders bevorzugt acht Prozessoren ausgebildet. Bei den Prozessoren handelt es sich besonders bevorzugt um RISC-Prozessoren. Durch den Aufbau eines Controllers 55 mit mindestens zwei Prozessoren ist es möglich, gleichzeitig zwei voneinander verschiedene Aufgaben in harter Echtzeit durchzuführen. So kann beispielsweise einer der Prozessoren die systemeigene Datenleitung, insbesondere den systemeigenen Bus auslesen bzw. überwachen, wobei der zweite Prozessor dann davon unabhängige bzw. verschiedene Aufgaben wahrnimmt. Diese Aufgaben können beispielsweise in der Kommunikation mit einem Einsteckmodul 7 und/oder einer Datenaufbereitung der Daten von dem Einsteckmodul 7 bestehen. Weiterhin können die aus dem systemeigenen Bus ausgelesenen Daten an das einsteckmodul weitergegebene werden, bzw. für dieses aufbereitet werden.

Ebenfalls können wiederum zwei Prozessoren redundant parallel arbeiten, so dass bei Ausfall eines Prozessors ein Funktionsprinzip durch den anderen Prozessor sichergestellt wird. Als besonderer Vorteil zeichnet sich bei dem erfindungsgemäßen Hardwaresystem durch den Aufbau mit mehreren Prozessoren die Arbeitsgeschwindigkeit aus. So ist es gegenüber herkömmlichen Controllern möglich, ohne Interrupt-Routinen zu arbeiten. Auch hierdurch wird wiederum die harte Echtzeitfähigkeit des erfindungsgemäßen Hardwaresystems sichergestellt. In besonders bevorzugter Ausführungsvariante werden Controller 55 mit acht Prozessoren eingesetzt, so dass sich bei einem spiegelsymmetrischen Aufbau auf einer Ebene 16 Prozessoren befinden.

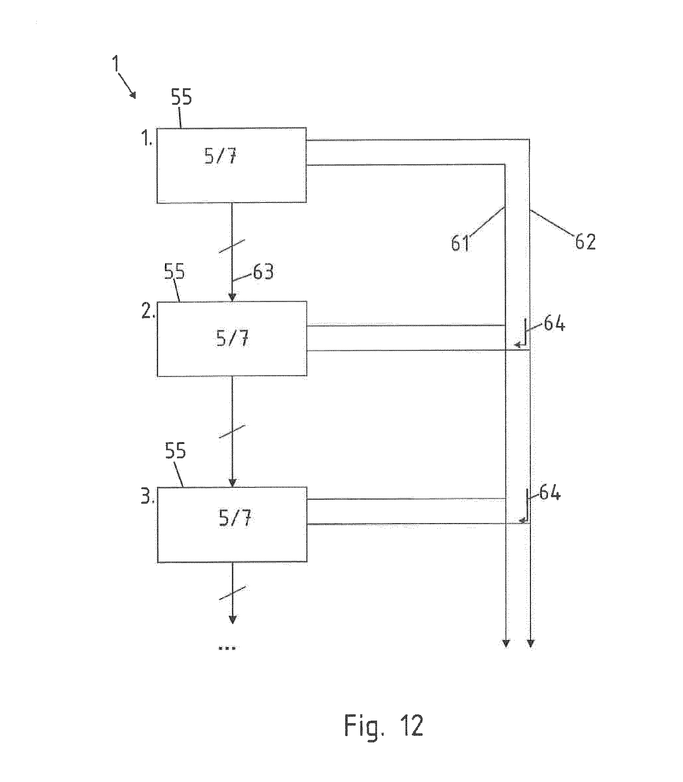

Figur 12 zeigt die erfindungsgemäße Möglichkeit der Autoadressierung des Hardwaresystems 1. Hierbei können die einzelnen Controller 55 der Modulebenen 5 oder aber auch ein jeweiliger Controller 55 eines Einsteckmoduls 7 innerhalb des Hardwaresystems 1 adressiert werden. Jeder Controller 55 muss dazu eine individuelle Nummer besitzen, um im Gesamthardwaresystem ansprechbar zu sein. Hierzu sind alle Controller 55 über Datenleitungen miteinander verbunden, die hier dargestellt in Form einer Senderleitung 61 und einer Empfängerleitung 62 ausgebildet sind. Die Controller 55 sind mit der Modularkonfiguration des Systems parallel an die Senderleitung 61 und die Empfängerleitung 62 angeschlossen.

Zur Autoadressierung müssen die Controller 55 jedoch in Reihe, also der Reihe nach, autoadressiert werden. Hierzu wird für einen ersten Controller 55 ein Resetsignal an den zweiten Controller 55 gesendet. Der erste Controller 55 bootet sich daraufhin neu. Er vertauscht seine Senderleitung 61 mit der Empfängerleitung 62, es wird also die Senderleitung 61 zur Empfängerleitung 62 und die Empfängerleitung 62 zur Senderleitung 61. Hierüber wird eine Kennung 64 an den zweiten Controller 55 gesendet. Der erste Controller 55 stellt anschließend seinen ursprünglichen Zustand von Senderdatum und Empfängerdatum wieder her. Daraufhin bootet der zweite Controller 55 neu und sendet an den dritten Controller 55 ebenfalls durch Vertauschen seiner Empfängerleitung 62 und Senderleitung 61 die Kennung 64 um plus 1 erhöht, woraufhin der dritte Controller 55 neu bootet. Die Autoadressierung kann sich folglich beliebig oft fortsetzen, wodurch das Hardwaresystem 1 mit durchaus bis zu mehr als 50 Controllern 55 erweiterbar ist. Die Controller 55 können untereinander mit einer Resetleitung 63 gekoppelt sein

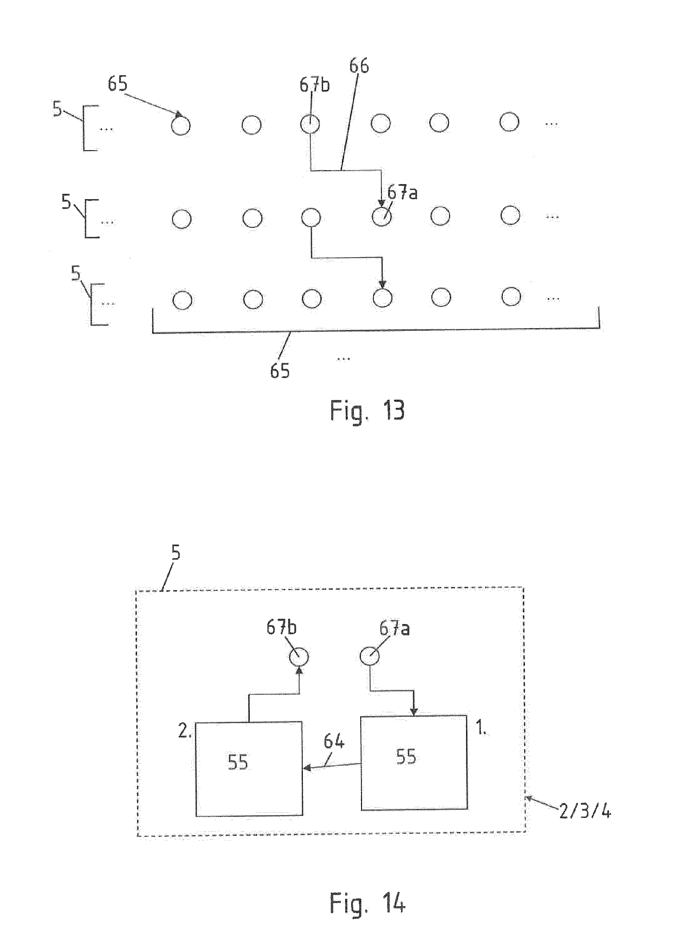

Damit die Controller ebenenübergreifend in Reihe schaltbar sind, muss ein jeweiliger Pfostenfeldstecker 65 einer Modulebene 5 einen Pinnversatz 66 der Resetleitung 67, die in Resetin 67a und Resetout 67b aufgeteilt ist, aufweisen. Hierdurch wird ebenenübergreifend, bei beliebiger modularer Erweiterungsmöglichkeit sichergestellt, dass das Resetsignal in Reihe weitergegeben wird, woraufhin sich die einzelnen Controller 55 fortlaufend autoadressieren. Dargestellt ist dies in Figur 13.

Figur 14 zeigt ergänzend, wie sich auf einer Modulebene 5, beispielsweise eines Grundmoduls 2 oder eines Zwischenmoduls 3 oder eines Deckelmoduls 4 zwei angeordnete Controller 55 entsprechend nacheinander autoadressieren. Zunächst kommt das Resetsignal über die Resetleitung 67 resetin 67a an, woraufhin der auf die Resetleitung 67 resetin 67a folgende erste Controller 55 sich bootet und das Resetsignal und die Kennung 64 um n plus 1 erhöht, an den zweiten Controller 55 auf der Modulebene 5 weitersendet, von wo aus das Resetsignal dann über die Restleitung 67 resetout auf die nächste, nicht näher dargestellte Modulebene 5 weitergegeben wird.

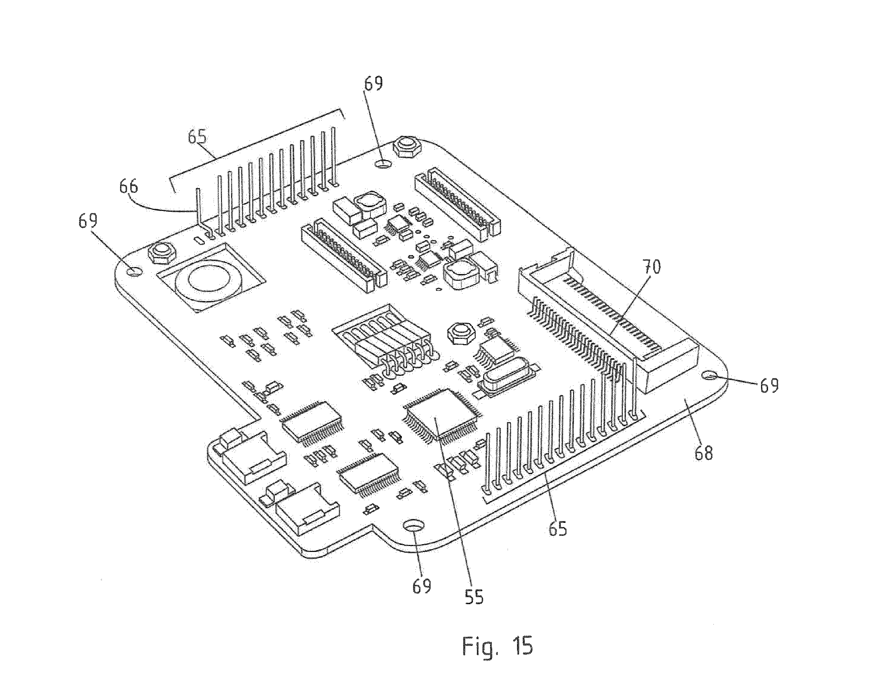

Figur 15 zeigt weiterhin eine Elektronikplatine 68, die dazu geeignet ist, in dem Gehäuse des erfindungsgemäßen Hardwaresystems 1 angeordnet zu werden. Die in Figur 15 gezeigte Platine eignet sich insbesondere zur Anordnung in dem Deckelmodul 4. Die Platine weist diverse Elektronikbauteile sowie mindestens einen Controller 55 auf. In Eckbereichen weist die Platine wiederum Montagelöcher 69 auf, die auf den Montagesockeln 25 in den einzelnen Modulebenen 5 anordnenbar sind und mit diesen verschraubbar sind. Ferner weist die Elektronikplatine 68 einen Pfostenfeldstecker 65 auf, wobei der auf die Bildebene bezogene hintere Pfostenfeldstecker einen Pinversatz 66 aufweist. Der Pinversatz 66 wird zur Autoadressierung genutzt. Ebenfalls ist ein Einsteckschachtstecker auf der Elektronikplatine angeordnet, in den das in einem Einsteckschacht 10 eingesteckte Einsteckmodul 7 lösbar steckbar ist.

### Bezugszeichen:

- 1: - Hardwaresystem
- 2: - Grundmodul
- 3: - Zwischenmodul
- 4: - Deckelmodul
- 5: - Modulebene zu 2 bis 4
- 6: - Zwischenschicht
- 7: - Einsteckmodul
- 8: - Kartenabschnitt zu 7
- 9: - Modulabschnitt zu 7
- 10: - Einstecköffnung zu 3
- 11: - Stecker
- 12: - Display
- 13: - Taster
- 14: - Oberseite
- 15: - vordere Einsteckseite
- 16: - hintere Einsteckseite
- 17: - vordere Seitenwand
- 18: - hintere Seitenwand
- 19: - Unterseite
- 20: - Spannungsanschluss
- 21: - abgerundete Ecke
- 22: - Gehäusewandung zu 15/16
- 23: - Gehäusewandung zu 17/18
- 24: - Ausnehmung
- 25: - Montagesockel
- 26: - innere Rundung
- 27: - Montagelöcher zu 25
- 28: - Montagelöcher zu 23/22
- 29: - Magnet
- 30: - Montageunterseite
- 31: - Steckeröffnung

- 32: - Öffnung zu 20
- 33: - Adapterstück zu 20
- 34: - Schraubverbindung
- 35: - Fuß
- 36: - Steckeröffnung
- 37: - Anlagefläche
- 38: - Einsteckmodulmagnet
- 39: - D-Sub-Stecker
- 40: - Pol
- 41: - Sicherungsschraube
- 42: - externe Versorgungsspannung
- 43: - interne Versorgungsspannung
- 44: - Netzteil
- 45: - Akkumulator
- 46: - Kraftfahrzeugbordnet
- 47: - Versorgungsleitung
- 48: - Spannungswandler 5 Volt
- 49: - Spannungswandler 3,3 Volt
- 50: - Modulebenenspannung 5 Volt
- 51: - Modulebenenspannung 3,3 Volt
- 52: - Lastversorgungsspannung
- 53: - Leistungstreiber
- 54: - Laststrom
- 55: - Controller
- 56: - Datentransfer
- 57: - externer Datentransfer
- 58: - externes Element
- 59: - Treiber
- 60: - Spiegelebene
- 61: - Senderleitung
- 62: - Empfängerleitung
- 63: - Resetleitung

- 64: - Kennung
- 65: - Pfostenfeldstecker
- 66: - Pinnversatz
- 67: - Resetleitung
- 67a: - Resetin
- 67b: - Resetout
- 68: - Elektronikplatine
- 69: - Montagelöcher
- 70: - Einsteckschacht

- L: - Länge
- B: - Breite

## Patentansprüche

1. Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, aufweisend eine Grundplatine mit einem Mastercontroller und mindestens eine Zusatzplatine mit einem Slavecontroller, **dadurch gekennzeichnet, dass** der Mastercontroller und der Slavecontroller über einen systemeigenen Bus, vorzugsweise über einen SPI Bus, des Hardwaresystems (1) kommunizieren, wobei an den Slavecontroller mindestens ein Einsteckmodul (7) anschließbar ist und über das Einsteckmodul (7) externe Regler und/oder Messsensoren und/oder Aktoren und/oder Datennetze auslesbar und/oder steuerbar sind.

2. Hardwaresystem nach Anspruch 1, **dadurch gekennzeichnet, dass** die Grundplatine in einem Grundmodul (2) angeordnet ist, wobei in das Grundmodul (2) optional ein Einsteckmodul (7) einsteckbar ist, wobei das Einsteckmodul (7) über den Mastercontroller ansteuerbar ist.

3. Hardwaresystem nach Anspruch 1 oder 2, **dadurch gekennzeichnet, dass** der Mastercontroller mit dem Einsteckmodul (7) über den systemeigenen Bus kommuniziert oder dass der Mastercontroller mit dem Einsteckmodul (7) über ein von dem systemeigenen Bus verschiedenes Datenprotokoll kommuniziert.

4. Hardwaresystem nach einem der Ansprüche 1 bis 3, **dadurch gekennzeichnet, dass** das Einsteckmodul (7) mit einem externen Element zum Datenaustausch und/oder elektrisch gekoppelt ist, wobei das Einsteckmodul (7) und das externe Element das Datenprotokoll des externen Elementes zur Kommunikation nutzen.

5. Hardwaresystem nach einem der Ansprüche 1 bis 4, **dadurch gekennzeichnet, dass** das Einsteckmodul (7) ein externes Datenprotokoll in ein ebeneninternes Datenprotokoll umwandelt, so dass auf einer Modulebene (5) des Grundmoduls (2) oder einer Modulebene (5) eines Zwischenmoduls (3) ein ebeneninterner Datentransfer (56) zwischen Einsteckmodul (7) und Controller (55) erfolgt.

6. Hardwaresystem nach einem der Ansprüche 1 bis 5, **dadurch gekennzeichnet, dass** nur für den primären Regelungsvorgang und/oder Messvorgang relevante Daten über den systemeigenen Bus austauschbar sind.

7. Hardwaresystem nach einem der Ansprüche 1 bis 6, **dadurch gekennzeichnet, dass** bei Start und/oder Reset und/oder bei Einstecken eines neuen Einsteckmoduls (7) und/oder in sich wiederholenden Abständen, insbesondere in zeitlich vorgegebenen Abständen, eine Autoadressierung aller im System angeordneten Ebenen und/oder Zwischenmodule (3) und/oder Einsteckmodule (7) erfolgt, bevorzugt ausgehend von dem Grundmodul (2), insbesondere ausgehend von dem ersten Einsteckmodul (7) des Grundmoduls (2).

8. Hardwaresystem nach Anspruch 7, **dadurch gekennzeichnet, dass** die Autoadressierung ausgehend vom Grundmodul (2) für alle Einsteckmodule (7) durchführbar ist.

9. Hardwaresystem nach einem der Ansprüche 1 bis 8, **dadurch gekennzeichnet, dass** die Einsteckmodule (7) zentral von dem Mastercontroller des Grundmoduls (2) aus ansteuerbar sind und/oder dass die Einsteckmodule (7) dezentral von einem Slavecontroller aus ansteuerbar sind, insbesondere ist der Slavecontroller auf einer Modulebene (5) angeordnet.

10. Hardwaresystem nach einem der Ansprüche 1 bis 9, **dadurch gekennzeichnet, dass** zwei oder mehr Einsteckmodule (7) in einem Zwischenmodul (3) zentral von einem in dem Zwischenmodul (3) befindlichen Slavecontroller aus ansteuerbar sind.

11. Hardwaresystem nach einem der Ansprüche 1 bis 10, **dadurch gekennzeichnet, dass** der Slavecontroller als Mikroprozessor ausgebildet ist, vorzugsweise ist der Slavecontroller durch zwei spiegelsymmetrische auf der Zusatzplatine angeordnete Mikroprozessoren ausgebildet.

12. Hardwaresystem nach einem der Ansprüche 1 bis 11, **dadurch gekennzeichnet, dass** ein Einsteckmodul (7) einen Speicherbaustein aufweist, auf dem eine Einsteckmodulkennung gespeichert ist, vorzugsweise ein EEPROM.

13. Verfahren zum Betreiben eines Hardwaresystems (1) nach mindestens einem der Ansprüche 1 bis 12, **dadurch gekennzeichnet, dass** ein externes Element (58) mit einem Einsteckmodul (7) kommuniziert, wobei das Einsteckmodul (7) die bereitgestellten und/oder abgefragten Daten filtert und zu einem mit dem Einschubmodul gekoppelten Slavecontroller weitergibt und/oder von diesem empfängt und dass der Slavecontroller die empfangenen oder gesendeten Daten über den systemeigenen Bus an den Mastercontroller weitergibt und/oder von diesem empfängt.

14. Verfahren nach Anspruch 13, **dadurch gekennzeichnet, dass** mindestens zwei Slavecontroller an den Mastercontroller angeschlossen werden und ein Datenprotokoll über den systemeigenen Bus gesendet wird, wobei jeder Slavecontroller die für ihn adressierten Daten aus dem Datenprotokoll ausliest und für ein ebeneninternes Datenprotokoll verwendet, wobei über das ebeneninterne Datenprotokoll die Einsteckmodule (7) über den jeweiligen Slavecontroller ansteuerbar sind.

15. Verfahren nach Anspruch 13 oder 14, **dadurch gekennzeichnet, dass** der Slavecontroller aufgrund der Modulkennung des Einsteckmoduls (7) die relevanten Daten aus dem systemeigenen Bus ausliest.

16. Verfahren zum Betreiben eines Hardwaresystems (1) gemäß mindestens einem der Patentansprüche 1 bis 12, **dadurch gekennzeichnet, dass** bei einem Hochfahren und/oder Programmstart des Hardwaresystems (1) der Mastercontroller alle Slavecontroller bezüglich gesteckter und/oder aktivierter Einsteckmodule (7) abfragt und eine Verbauliste erstellt, wobei die Verbauliste mit einer Sollverbauliste verglichen wird.

17. Verfahren nach Anspruch 16, **dadurch gekennzeichnet, dass** bei Auftreten einer Differenz zwischen der Verbauliste und der Sollverbauliste eine Fehlermeldung erzeugt wird.

18. Verfahren nach Anspruch 16 oder 17, **dadurch gekennzeichnet, dass** die Sollverbauliste automatisch durch eine Initialisierung des Hardwaresystems (1) bei Erstinbetriebnahme oder Wiederinbetriebnahme vorgenommen wird oder dass die Sollverbauliste manuell editiert wird.

19. Verfahren nach einem der Ansprüche 16 bis 18, **dadurch gekennzeichnet, dass** der Vergleich während des Betriebs des Hardwaresystems (1) in zeitlichen Abständen durchgeführt wird, insbesondere in zyklischen Abständen.

20. Verfahren nach einem der Ansprüche 13 bis 19, **dadurch gekennzeichnet, dass** bei Ausfall eines Slavecontrollers auf einer Zusatzplatine die Ansteuerung der Einsteckmodule (7) über einen Slavecontroller einer anderen Zusatzplatine oder über den Mastercontroller vorgenommen wird.

21. Verfahren nach einem der Ansprüche 13 bis 20, **dadurch gekennzeichnet, dass** jedes Einsteckmodul (7) ein Speicherbaustein aufweist, wobei der Slavecontroller einer jeden Zusatzebene mit dem Speicherbaustein des Einsteckmoduls (7) kommuniziert, vorzugsweise über einen ebeneninternen Bus.

22. Verfahren nach einem der Ansprüche 13, bis 21 **dadurch gekennzeichnet, dass** der Slavecontroller mit dem Mastercontroller über einen systemeigenen Bus kommuniziert, wobei die Daten des Mastercontrollers über das Display (12) und/oder eine externe Dateneinrichtung ausgelesen und/oder von dem Display (12) und/oder einer externen Dateneinrichtung eingegeben werden.

23. Verfahren nach einem der Ansprüche 13 bis 22, **dadurch gekennzeichnet, dass** über den Mastercontroller eine Modellbildungssoftware, insbesondere Matlab/Simulink, in das Hardwaresystem (1) eingebunden wird.

24. Verfahren nach einem der Ansprüche 13 bis 23, **dadurch gekennzeichnet, dass** zwischen den Modulebenen (2/3/4) und den voneinander verschiedenen Datenprotokollen in Echtzeit kommuniziert wird.
